# EUROPEAN PATENT APPLICATION

(11) **EP 4 465 344 A1**
(43) Date of publication of application: **20.11.2024**
(21) Application number: 24176737.5
(22) Date of filing: 17.05.2024
(51) Int. Cl.: H01L 21/822, H01L 21/8238, H01L 23/528, H01L 27/06, H01L 27/092, H01L 29/417, H01L 29/66, H01L 29/775

(54) **HIGH PERFORMANCE SEMICONDUCTOR DEVICES USING MULTI-BRIDGE-CHANNEL FIELD EFFECT TRANSISTORS**

(30) Priority: 19.05.2023 KR 20230064853
(71) Applicant: Samsung Electronics Co., Ltd., Suwon-si, Gyeonggi-do 16677 (KR)
(72) Inventor: LEE, Kyenhee, 16677 Suwon-si (KR); KIM, Kyungsoo, 16677 Suwon-si (KR)
(74) Representative: Marks & Clerk LLP

(57) **Abstract**

A semiconductor device includes: an active pattern (105) extending on a substrate (101) in a first direction (X); first to fourth channel structures stacked, in order, on one region of the active pattern; first and second gate structures respectively crossing the first and second and the third and fourth channel structures, and extending in a second direction (Y); first to fourth source/drain patterns, respectively, connected to both ends of the first to fourth channel structures; a plurality of upper contact vias electrically connecting each of a plurality of upper wiring lines (M1a, M1b, M1C) to at least one of the first to fourth source/drain patterns; a plurality of lower wiring lines (M2a, M2b, M2c) disposed on a lower surface of the substrate (101); and a plurality of lower contact vias penetrating through the substrate and electrically connecting each of the plurality of lower wiring lines to at least one of the first to fourth source/drain patterns.

## Description

### BACKGROUND

Example embodiments of the inventive concept(s) relate to semiconductor devices.

As demands for high performance, high speed, and/or multifunctionality of semiconductor devices have increased, integration density of semiconductor devices has increased. To overcome limitations in operating properties caused by reductions in size of planar metal oxide semiconductor field effect transistors (FETs), efforts have been made to develop semiconductor devices, such as FinFETs, which include a fin-type channel, and gate-all-around-type field effect transistors, which may include conductive nanosheet "channel" regions surrounded by a gate.

### SUMMARY

Example embodiments of the inventive concept provide semiconductor devices having improved electrical properties and reliability.

According to an example embodiment of the inventive concept, a semiconductor device includes: an active pattern (e.g., fin-shaped active pattern) extending on a substrate in a first direction, and first to fourth channel structures stacked in order on one region of the active pattern, where the first to fourth channel structures include a plurality of first to fourth semiconductor patterns stacked and spaced apart from each other in a direction perpendicular to an upper surface of the substrate, respectively. A first gate structure is also provided, which crosses the one region of the active pattern, extends in a second direction intersecting the first direction, and surrounds the plurality of first and second semiconductor patterns. A second gate structure is provided, which extends on the first gate structure in the second direction and surrounds the plurality of third and fourth semiconductor patterns. A pair of first source/drain patterns are provided, which are connected to both ends of the plurality of first semiconductor patterns, respectively, on both sides of the first gate structure. Similarly, a pair of second source/drain patterns are provided, which are connected to both ends of the plurality of second semiconductor patterns, respectively, on both sides of the first gate structure. In addition, a pair of third source/drain patterns are provided, which are connected to both ends of the plurality of third semiconductor patterns, respectively, on both sides of the second gate structure. And, a pair of fourth source/drain patterns are provided, which are connected to both ends of the plurality of fourth semiconductor patterns, respectively, on both sides of the second gate structure. An interlayer insulating layer is also provided, which covers the first to fourth source/drain patterns, and a plurality of upper wiring lines are disposed on the interlayer insulating layer. A plurality of upper contact vias are provided, which electrically connect each of the plurality of upper wiring lines to at least one of the first to fourth source/drain patterns. A plurality of lower wiring lines are provided, which extend on a lower surface of the substrate. And, a plurality of lower contact vias are provided, which penetrate through the substrate and electrically connect each of the plurality of lower wiring lines to at least one of the first to fourth source/drain patterns.

According to another example embodiment of the inventive concept, a semiconductor device includes an active pattern extending on a substrate, a first channel structure, which includes a plurality of first semiconductor patterns stacked and spaced apart from each other on one region of the active pattern, and a second channel structure, which includes a plurality of second semiconductor patterns stacked and spaced apart from each other on the first channel structure. A third channel structure is provided, which includes a plurality of third semiconductor patterns stacked and spaced apart from each other on the second channel structure, along with a fourth channel structure, which includes a plurality of fourth semiconductor patterns stacked and spaced apart from each other on the third channel structure. A gate structure is provided, which crosses the one region of the active pattern and surrounds the plurality of first to fourth semiconductor patterns. A pair of first source/drain patterns are provided, which are connected to both ends of the plurality of first semiconductor patterns, respectively, on both sides of the gate structure. A pair of second source/drain patterns are provided, which extend on the pair of first source/drain patterns and are connected to both ends of the plurality of second semiconductor patterns, respectively. A pair of third source/drain patterns are provided, which extend on the pair of second source/drain patterns and are connected to both ends of the plurality of third semiconductor patterns, respectively. A pair of fourth source/drain patterns are provided, which extend on the pair of third source/drain patterns and are connected to both ends of the plurality of fourth semiconductor patterns, respectively. In addition, first contact structures are provided, which are connected to the first to fourth source/drain patterns and are disposed on one side of both sides of the gate structure, respectively. Second contact structures are provided, which are connected to the first to fourth source/drain patterns and are disposed on the other side on both sides of the gate structure, respectively. A first power line and a second power line are provided, which extend on a lower surface of the substrate. A first power transfer via is provided that penetrates through the substrate and electrically connects the first power line to at least one of the first contact structures. A second power transfer via is provided that penetrates through the substrate and electrically connects the second power line to at least one of the second contact structures.

According to another example embodiment of the inventive concept, a semiconductor device is provided that includes an active pattern extending on a substrate in a first direction, a first channel structure including a plurality of first semiconductor patterns that are stacked and spaced apart from each other on one region of the active pattern in a direction perpendicular to an upper surface of the substrate, a second channel structure including a plurality of second semiconductor patterns that are stacked and spaced apart from each other in the vertical direction on the first channel structure, a third channel structure including a plurality of third semiconductor patterns that are stacked and spaced apart from each other in the vertical direction on the second channel structure, and a fourth channel structure including a plurality of fourth semiconductor patterns that are stacked and spaced apart from each other in the vertical direction on the third channel structure. A first intermediate insulating pattern is provided, which extends between the first channel structure and the second channel structure, and a second intermediate insulating pattern is provided, which extends between the third channel structure and the fourth channel structure. A first gate structure is provided, which crosses the one region of the active pattern, extends in a second direction intersecting the first direction, and surrounds the plurality of first semiconductor patterns and the plurality of second semiconductor patterns. A second gate structure is provided, which extends on the first gate structure in the second direction, and surrounds the plurality of third semiconductor patterns and the plurality of fourth semiconductor patterns. An inter-gate insulating layer is provided, which extends between the first gate structure and the second gate structure. A pair of first source/drain patterns are provided, which extend on the active pattern on both sides of the first gate structure, and are connected to both ends of the plurality of first semiconductor patterns, respectively. A pair of second source/drain patterns are provided, which are connected to both ends of the plurality of second semiconductor patterns, respectively, on both sides of the first gate structure. A pair of third source/drain patterns are provided, which are connected to both ends of the plurality of third semiconductor patterns, respectively, on both sides of the second gate structure. A pair of fourth source/drain patterns are provided, which are connected to both ends of the plurality of fourth semiconductor patterns, respectively, on both sides of the second gate structure. An interlayer insulating layer is provided, which covers the first to fourth source/drain patterns. A plurality of first wiring lines are provided, which extend on the interlayer insulating layer. A plurality of first contact vias are provided, which connect each of the plurality of first wiring lines to at least one of the first to fourth source/drain patterns through the interlayer insulating layer. A plurality of second wiring lines are provided, which extend on a lower surface of the substrate. And, a plurality of second contact vias are provided, which electrically connect each of the plurality of second wiring lines to at least one of the first to fourth source/drain patterns through the substrate.

According to a further embodiment of the inventive concept, a semiconductor device is provided, which includes an active pattern extending on a substrate in a first direction, a first channel structure including a plurality of first semiconductor patterns that are stacked and spaced apart from each other on one region of the active pattern in a direction perpendicular to an upper surface of the substrate, and a second channel structure including a plurality of second semiconductor patterns that are stacked and spaced apart from each other in the vertical direction on the first channel structure. An intermediate insulating pattern is provided, which extends between the first channel structure and the second channel structure. A gate structure is provided, which crosses the one region of the active pattern, extends in a second direction intersecting the first direction, and surrounds the plurality of first semiconductor patterns and the plurality of second semiconductor patterns. A pair of first source/drain patterns are provided, which extend on the active pattern on both sides of the gate structure, and are connected to both ends of the plurality of first semiconductor patterns, respectively. A pair of second source/drain patterns are provided, which are connected to both ends of the plurality of second semiconductor patterns, respectively, on both sides of the gate structure. The plurality of first semiconductor patterns may be arranged to partially overlap the plurality of second semiconductor patterns in the vertical direction, on a cross-sectional surface in the second direction.

At least some of the above and other features of the invention are set out in the claims.

### BRIEF DESCRIPTION OF DRAWINGS

The above and other aspects, features, and advantages in the example embodiment will be more clearly understood from the following detailed description, taken in combination with the accompanying drawings, in which:
FIG. 1 is a plan diagram illustrating a semiconductor device according to an example embodiment of the present disclosure;
FIG. 2 is an equivalent circuit diagram illustrating the semiconductor device illustrated in FIG. 1;
FIG. 3 is a cross-sectional diagram illustrating the semiconductor device illustrated in FIG. 1, taken along line I-I';
FIG. 4 is a cross-sectional diagram illustrating the semiconductor device illustrated in FIG. 1, taken along line II-II';
FIGS. 5A and 5B are cross-sectional diagrams illustrating the semiconductor device illustrated in FIG. 1, taken along lines III1-III1' and III2-III2';
FIG. 6 is a plan diagram illustrating a semiconductor device according to an example embodiment of the present disclosure;
FIGS. 7A and 7B are cross-sectional diagrams illustrating the semiconductor device illustrated in FIG. 6, taken along lines III1-III1' and III2-III2';
FIG. 8 is a plan diagram illustrating a semiconductor device according to an example embodiment of the present disclosure;
FIG. 9 is an equivalent circuit diagram illustrating the semiconductor device illustrated in FIG. 8;
FIG. 10 is a cross-sectional diagram illustrating the semiconductor device illustrated in FIG. 8, taken along line I-I';
FIGS. 11A and 11B are cross-sectional diagrams illustrating the semiconductor device illustrated in FIG. 8, taken along lines III1-III1' and III 2-III2';
FIG. 12 is a plan diagram illustrating a semiconductor device according to an example embodiment of the present disclosure;
FIG. 13 is an equivalent circuit diagram illustrating the semiconductor device illustrated in FIG. 12;
FIG. 14 is a cross-sectional diagram illustrating the semiconductor device illustrated in FIG. 12, taken along line I-I';
FIGS. 15A and 15B are cross-sectional diagrams illustrating the semiconductor device illustrated in FIG. 12, taken along lines II1-II1' and II2-II2';
FIGS. 16A to 16D are cross-sectional diagrams illustrating the semiconductor device illustrated in FIG. 12, taken along lines III1-III1', III2-III2', III3-III3' and III4-III4';
FIG. 17 is a perspective diagram illustrating a semiconductor device according to an example embodiment of the present disclosure;
FIGS. 18A and 18B are cross-sectional diagrams illustrating the semiconductor device illustrated in FIG. 17, taken along lines D1a-D1a' and D1b-D1b';
FIGS. 19A and 19B are cross-sectional diagrams illustrating the semiconductor device illustrated in FIG. 17, taken along lines D2a-D2a' and D2b-D2b';
FIGS. 20A to 20C are cross-sectional diagrams illustrating a process of manufacturing a semiconductor device according to an example embodiment of the present disclosure;
FIG. 21 is a cross-sectional diagram illustrating a semiconductor device according to an example embodiment of the present disclosure; and
FIGS. 22A and 22B are cross-sectional diagrams illustrating the semiconductor device illustrated in FIG. 21, taken along lines Z1-Z1' and Z2-Z2'.

### DETAILED DESCRIPTION

Hereinafter, embodiments in the example embodiment will be described as follows with reference to the accompanying drawings.

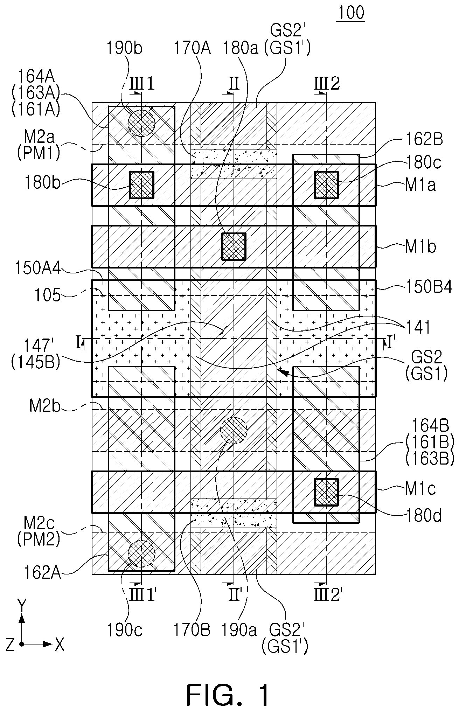

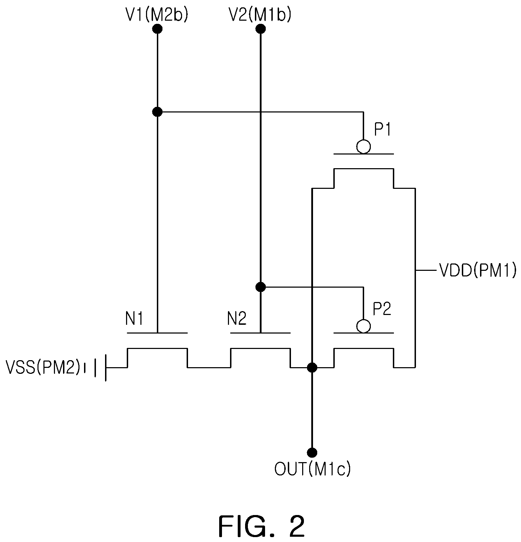

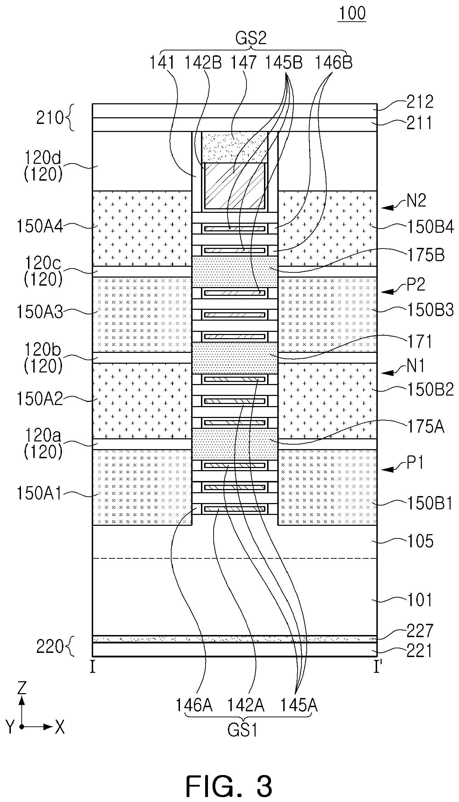

FIG. 1 is a plan diagram illustrating a semiconductor device according to an example embodiment. FIG. 2 is an equivalent circuit diagram illustrating the semiconductor device illustrated in FIG. 1. FIG. 3 is a cross-sectional diagram illustrating the semiconductor device illustrated in FIG. 1, but taken along line I-I'. Referring to FIGS. 1 and 3, the semiconductor device 100 according to the example embodiment may include a substrate 101, a first transistor P1, a second transistor N1, a third transistor P2, and a fourth transistor N2, which are vertically stacked in order on the substrate 101 as first to fourth transistors P1, N1, P2, and N2, as shown by FIG. 3.

As shown, the first to fourth transistors P1, N1, P2, and N2 employed in the example embodiment may be stacked on the substrate 101 in a direction perpendicular to an upper surface of the substrate 101 (e.g., Z-direction, or vertical direction), and may be interconnected by a plurality of upper and lower wiring lines M1a, M1b, M1c, M2a, M2b, and M2c and a plurality of upper and lower contact vias 180a, 180b, 180c, 190a, 190b, and 190c, as shown by FIG. 1. As illustrated in FIG. 2, the four transistors P1, N1, P2, and N2 may be implemented as a two-input NAND logic circuit by the aforementioned interconnection structures, and the semiconductor device according to the example embodiment may be provided as a NAND logic unit cell within an integrated circuit. The terms "above, "below, "upper", "middle", "lower", etc. may refer to relative positions along a particular direction (e.g. a vertical direction). Various directions (e.g. vertical direction, horizontal direction, etc.) may be defined relative to the structure of the devices described herein. It will be appreciated that these directions do not necessarily imply any particular orientation of the device in use.

In the example embodiment, each of the first and third transistors P1 and P2 may be implemented as a P-type Metal-Oxide-Semiconductor Field Effect Transistor (MOSFET), and each of the second and fourth transistors N1 and N2 may be implemented as an N-type MOSFET. The first to fourth transistors P1, N1, P2, and N2 employed in the example embodiment may be implemented as a Multi Bridge Channel FET (MBCFET) including gate structures GS1 and GS2 surrounding a plurality of semiconductor patterns 131A, 132A, 131B, and 132B stacked and spaced apart from each other in the vertical direction (Z-direction). One example of a conventional MBCFET is disclosed in an article by G. Bae et al., entitled: "3nm GAA Technology featuring Multi-Bridge-Channel FET for Low Power and High Performance Applications," 2018 IEEE International Electron Devices Meeting (IEDM), San Francisco, CA, USA, 2018, pp. 28.7.1-28.7.4, the disclosure of which is hereby incorporated herein by reference.

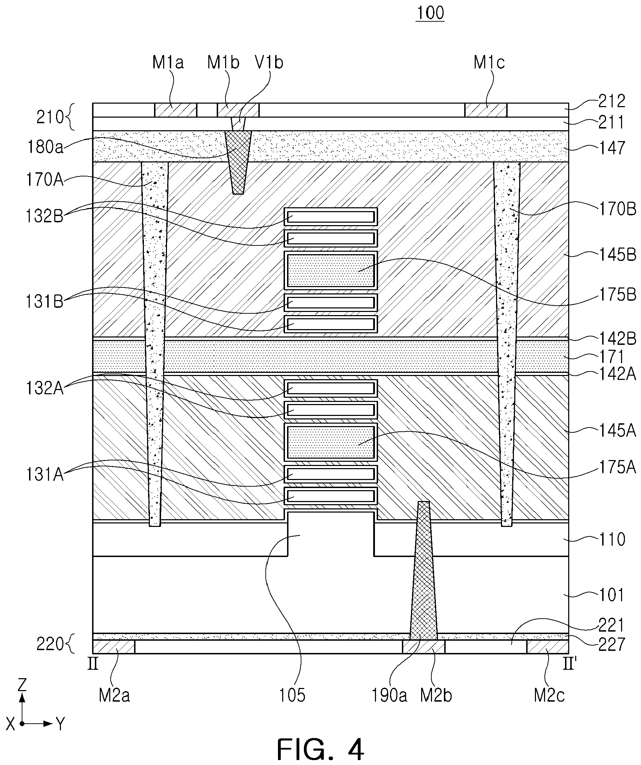

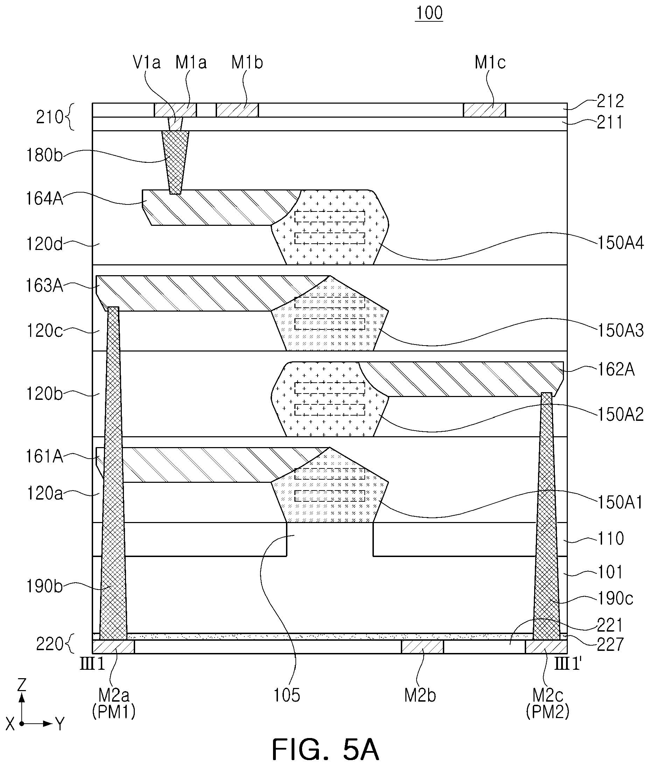

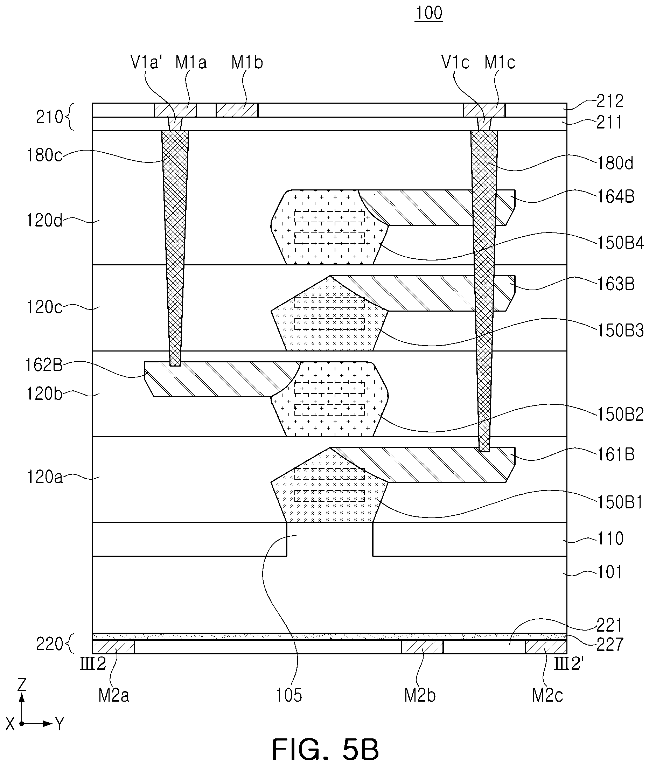

Referring to FIGS. 4, 5A and 5B together with FIGS. 1 to 3, the detailed structure of the semiconductor device 100 according to the example embodiment, particularly the configuration of each transistor, will be described in greater detail. In particular, FIG. 4 is a cross-sectional diagram illustrating the semiconductor device illustrated in FIG. 1 taken along line II-II'. FIGS. 5A and 5B are cross-sectional diagrams illustrating the semiconductor device illustrated in FIG. 1 taken along lines III1-III1' and III2-III2'.

In some embodiments, the substrate 101 may include a semiconductor material, for example, a group IV semiconductor, a group III-V compound semiconductor, or a group II-VI compound semiconductor. For example, a group IV semiconductor may include silicon (Si), germanium (Ge), or silicon germanium (SiGe). The substrate 101 may include a bulk wafer, an epitaxial layer, or a silicon on insulator (SOI) layer.

As illustrated in FIG. 1, the active pattern 105 may have a fin-shaped structure extending from the substrate 101 in the vertical direction, and extending in a first direction (X-direction). The first direction may be perpendicular to the vertical direction (Z-direction). As illustrated in FIGS. 4, 5A and 5B, the device isolation film 110 may define the active pattern 105 on the substrate 101. The device isolation film 110 may be disposed on the substrate 101, and a portion of the active pattern 105 may protrude from an upper surface of an opening in the device isolation film 110. The device isolation film 110 may be formed by, for example, a shallow trench isolation (STI) process. The device isolation film 110 may include an insulating material, such as silicon oxide, silicon nitride, silicon oxynitride, or a combination thereof, for example.

Referring to FIGS. 3 and 4, first to fourth channel structures may be stacked, in order, on one region of the active pattern 105. The first to fourth channel structures may include a plurality of first to fourth semiconductor patterns 131A, 132A, 131B, and 132B (also referred to as "first to fourth channel layers") stacked and spaced apart from each other in a direction perpendicular to the upper surface of the substrate 101, respectively.

The first transistor P1 may include a plurality of first semiconductor patterns 131A stacked on the active pattern 105, and the second transistor N1 may include a plurality of second semiconductor patterns 132A stacked on the plurality of first semiconductor patterns 131A. A first intermediate insulating pattern 175A may be disposed between the plurality of first semiconductor patterns 131A and the plurality of second semiconductor patterns 132A and may isolate the first and second channel structures from each other. As shown, the first intermediate insulating pattern 175A may be disposed between an uppermost first semiconductor pattern of the plurality of first semiconductor patterns 131A and a lowermost second semiconductor pattern of the plurality of second semiconductor patterns 132A.

Similarly, the third transistor P2 may include the plurality of third semiconductor patterns 131B stacked on the active pattern 105, and the fourth transistor N2 may include a plurality of fourth semiconductor patterns 132B stacked on the plurality of third semiconductor patterns 131B. A second intermediate insulating pattern 175B may be disposed between the plurality of third semiconductor patterns 131B and the plurality of fourth semiconductor patterns 132B and may isolate the third and fourth channel structures from each other. As shown, the second intermediate insulating pattern 175B may be disposed between an uppermost third semiconductor pattern of the plurality of third semiconductor patterns 131B and a lowermost fourth semiconductor pattern of the plurality of fourth semiconductor patterns 132B.

Thus, a plurality of the first to fourth semiconductor patterns 131A, 132A, 131B, and 132B (e.g., two or three semiconductor patterns) may be provided. For instance, first to fourth pluralities of semiconductor patterns 131A, 132A, 131B and 132B may be provided (e.g. each plurality comprising two or more semiconductor patterns). For example, the first to fourth semiconductor patterns 131A, 132A, 131B, and 132B may include at least one of silicon (Si), silicon germanium (SiGe), and germanium (Ge). The first and second intermediate insulating patterns 175A and 175B may include an insulating material including at least one of silicon nitride, silicon oxynitride, and silicon carbonitride, for example. Each of the first and second intermediate insulating patterns 175A and 175B may be configured as a single insulating material layer, or may include a plurality of insulating material layers in some example embodiments.

In the example embodiment, the first and second transistors P1 and N1 may include a first gate structure GS1 extending in a second direction (Y-direction) intersecting the first direction (X-direction) as a shared gate. The second direction (Y-direction) may be perpendicular to the vertical direction. The first gate structure GS1 may include a first gate electrode 145A surrounding each of the plurality of first and second semiconductor patterns 131A and 132A, and a first gate insulating film 142A disposed between the first and second semiconductor patterns 131A and 132A and the first gate electrode 145A. In the example embodiment, the first gate structure GS1 may further include first internal spacers 146A provided on both sides of portions of first gate electrode 145A in the first direction (X-direction) between the plurality of first and second semiconductor patterns 131A and 132A. The first internal spacers 146A may electrically insulate the portions of the first gate electrode 145A from the first and second source/drain patterns 150A1, 150B1, and 150A2, 150B2 on both sides thereof.

Similarly, in the example embodiment, the third and fourth transistors P2 and N2 may include a second gate structure GS2 extending in the second direction (Y-direction) as a shared gate. The inter-gate insulating layer 171 may be disposed between first gate structure GS1 and second gate structure GS2, and may electrically isolate the first gate structure GS1 and the second gate structure GS2 from each other. The inter-gate insulating layer 171 may include an insulating material, and may include, for example, at least one of silicon nitride, silicon oxynitride, and silicon carbonitride. The second gate structure GS2 may include a second gate electrode 145B surrounding each of the plurality of third and fourth semiconductor patterns 131B and 132B, and a second gate insulating film 142B disposed between the third and fourth semiconductor patterns 131B and 132B and the second gate electrode 145B. In the example embodiment, the second gate structure GS2 may further include a pair of gate spacers 141, a gate capping layer 147 disposed on the second gate electrode 145B between the pair of gate spacers 141, and second internal spacers 146B. Similarly to the first internal spacers 146A, the second internal spacers 146B may be provided on both sides of portions of second gate electrode 145B in the first direction (X-direction) between the plurality of third and fourth semiconductor patterns 131B and 132B. The second internal spacers 146B may electrically insulate the portions of the second gate electrode 145B from the third and fourth source/drain patterns 150A3, 150B3, 150A4, and 150B4 on both sides thereof.

The first and second gate electrodes 145A and 145B may include the same material or different materials. In some example embodiments, the first and second gate electrodes 145A and 145B may be configured as multilayers including two or more films. The first gate electrode 145A and the second gate electrode 145B may include different numbers of layers. The first and second gate electrodes 145A and 145B may include a highly conductive material, for example, a metal nitride such as titanium nitride (TiN), tantalum nitride (TaN), or tungsten nitride (WN), and/or metal materials such as aluminum (AL), tungsten (W), or molybdenum (Mo) or semiconductor materials such as doped polysilicon.

The first and second gate insulating films 142A and 142B may include the same material or different materials. In some example embodiments, the first and second gate insulating films 142A and 142B may be configured as multiple layers including two or more films. The first and second gate insulating films 142A and 142B may include different numbers of layers. For example, the first and second gate insulating films 142A and 142B may be formed of, for example, a silicon oxide film, a high dielectric film, or a combination thereof. The high dielectric film may include a material selected from hafnium oxide, hafnium oxynitride, hafnium silicon oxide, lanthanum oxide, lanthanum aluminum oxide and combinations thereof, but an example embodiment thereof is not limited thereto.

For example, the gate spacers 141 may include an insulating material such as silicon nitride (SiN), silicon oxynitride (SiON), silicon carbonitride (SiCN), or silicon oxycarbonitride (SiOCN). The gate capping layer 147 may include, for example, silicon nitride, silicon oxynitride, silicon carbonitride, or silicon oxycarbonitride.

In the example embodiment, first and second gate structures GS1 and GS2 may be defined by the gate isolation patterns 170A and 170B (see FIG. 1). Referring to FIG. 4, the gate isolation patterns 170A and 170B may extend up to the device isolation layer 110 such that the line-shaped gate structure may be divided into a plurality of gate structures GS1, GS1', GS2 and GS2'. The gate isolation patterns 170A and 170B may include an insulating material, and may include, for example, at least one of silicon nitride, silicon oxynitride, and silicon carbonitride.

Referring to FIGS. 5A and 5B together with FIGS. 3 and 4, the first transistor P1 may further include a pair of first source/drain patterns 150A1 and 150B1 connected to both ends of the plurality of first semiconductor patterns 131A, respectively, on both sides of the first gate structure GS1, and the second transistor N1 may further include a pair of second source/drain patterns 150A2 and150B2 connected to both ends of the plurality of second semiconductor patterns 132A, respectively, on both sides of the first gate structure GS1.

Similarly, the third transistor P2 further may include a pair of third source/drain patterns 150A3 and 150B3 connected to both ends of the plurality of third semiconductor patterns 131B, respectively, on both sides of the second gate structure GS2, and the fourth transistor N2 may further include a pair of fourth source/drain regions 150A4 and 150B4 connected to both ends of the plurality of fourth semiconductor patterns 132B, respectively, on both sides of the second gate structure GS2.

The first source/drain pattern 150A1 and 150B1 may be epitaxial grown, selectively, using recessed surfaces of the active pattern 105 on both sides of the first gate structure GS1 and side surfaces of the plurality of first semiconductor patterns 131A as seeds. The second source/drain patterns 150A2 and 150B2 may include epitaxial layers selectively grown on both sides of the first gate structure GS1 using side surfaces of the plurality of second semiconductor patterns 132A as epitaxial "seeds." Similarly, the third source/drain pattern 150A3 and 150B3 may be epitaxial grown from side surfaces of the plurality of third semiconductor patterns 131B on both sides of second gate structure GS2, and the fourth source/drain pattern 150A4 and 150B4 may include epitaxial layers grown from side surfaces of the plurality of fourth semiconductor patterns 132B on both sides of the second gate structure GS2. Moreover, the first to fourth source/drain patterns 150A1, 150B1, 150A2, 150B2, 150A3, 150B3, and 150A4, 150B4 may be Si, SiGe, or Ge, and may have an N-type conductivity or a P-type conductivity.

In the example embodiment, as described hereinabove, each of the first and third transistors P1 and P2 may be configured as a P-type MOSFET, and each of the second and fourth transistors N1 and N2 may be configured as an N-type MOSFET. That is, each of the first source/drain patterns 150A1, 150B1 and the third source/drain patterns 150A3 and 150B3 may be formed as a P-type source/drain region, and each of the second source/drain patterns 150A2 and 150B2 and the fourth source/drain patterns 150A4 and 150B4 may be formed as an N-type source/drain region.

Thus, for example, the P-type source/drain region may include SiGe doped with P-type impurities, and the P-type impurities may include boron (B), indium (In), gallium (Ga), boron trifluoride (BF3), or the like. Also, the N-type source/drain region may include silicon (Si) doped with N-type impurities, and the N-type impurities may include phosphorus (P), nitrogen (N), arsenic (As), antimony (Sb), and the like. And, because the P-type source/drain region and the N-type source/drain region are formed of different semiconductor materials, the source/drain regions may have different shapes along the crystallographically stable plane during the growth process. For example, as illustrated in FIGS. 5A and 5B, the first source/drain patterns 150A1 and 150B1 and the third source/drain patterns 150A3 and 150B3 may have pentagonal cross-sectional surfaces, whereas the second source/drain patterns 150A2 and 150B2 and the fourth source/drain patterns 150A4 and 150B4 may have a hexagonal or polygonal cross-sectional surface with more gentle (e.g. less acute, or more rounded) angles.

Referring to FIGS. 3 and 5A and 5B, the semiconductor device 100 according to the example embodiment may include first to fourth source/drain patterns 150A1 and 150B1 to 150A4 and 150B4 on both sides of first and second gate structures GS1 and GS2 on a substrate 101, and an interlayer insulating layer 120 covering 150A1, 150B1, 150A2, 150B2, 150A3, 150B3, and 150A4, 150B4. The interlayer insulating layer 120 may include a first interlayer insulating film 120a surrounding the first transistor P1, a second interlayer insulating film 120b surrounding the second transistor N1 on the first interlayer insulating film 120a, a third interlayer insulating film 120c surrounding the third transistor P2 on the second interlayer insulating film 120b, and a fourth interlayer insulating film 120d surrounding the fourth transistor N2 on the third interlayer insulating film 120c.

The first interlayer insulating film 120a may be formed to cover the first source/drain patterns 150A1 and 150B1, and the second interlayer insulating film 120b may be formed to cover second source/drain patterns 150A2 and 150B2. The third and fourth interlayer insulating films 120c and 120d may be formed to cover the third and fourth source/drain patterns 150A3 and 150B3 and 150A4 and 150B4, respectively. The first to fourth interlayer insulating films 120a, 120b, 120c, and 120d may be formed after selective epitaxial growth for corresponding source/drain patterns, respectively. As such, the interlayer insulating layer 120 may electrically insulate the first to fourth source/drain patterns 150A1 and 150B1, 150A2 and 150B2, 150A3 and 150B3, and 150A4 and 150B4 from each other.

In some example embodiments, the interlayer insulating layer 120 and each of the first to fourth interlayer insulating films 120a, 120b, 120c, and 120d may be silicon oxide. For example, the interlayer insulating layer 120 may be spin-on hardmask (SOH), flowable oxide (FOX), tonen silazane (TOSZ), undoped silica glass (USG), borosilica glass (BSG), phosphosilaca glass (PSG), borophosphosilica glass (BPSG), plasma enhanced tetra ethyl ortho silicate (PETEOS), fluoride silicate glass (FSG), high density plasma oxide (HDP), plasma enhanced oxide (PEOX), flowable CVD (FCVD) oxide, or a combination thereof. Each of the first to fourth interlayer insulating films 120a, 120b, 120c, and 120d may be formed using a chemical vapor deposition (CVD) process or a spin coating process. In some example embodiments, each of the first to fourth interlayer insulating films 120a, 120b, 120c, and 120d may be formed of the same material, and the interfacial surfaces between the films may be visually distinct.

The semiconductor device 100 according to the example embodiment may include a first interconnection structure 210 (also referred to as a "front side interconnection structure") disposed on a front side thereof and a second interconnection structure 220 (also referred to as a "back side interconnection structure") disposed on a back side thereof. It will be appreciated that in this context, "front" and "back" are relative terms, and need not indicate any particular orientation of the semiconductor device 100 in use. Referring to FIGS. 3 to 5A and 5B, the first interconnection structure 210 may include first wiring insulating layers 211 and 212 disposed on the interlayer insulating layer 120 and first to third upper wiring lines M1a, M1b, and M1c on the first wiring insulating layers 211 and 212. Similarly, the second interconnection structure 220 may include a second wiring insulating layer 221 disposed on the lower surface of the substrate 101 and first to third lower wiring lines M2a, M2b, and M2c in the second wiring insulating layer 221. In the example embodiment, an etch stop film 227 may be disposed between the substrate 101 and the second wiring insulating layer 221. The etch stop film 227 may be used in a process of forming the first to third lower wiring lines M2a, M2b, and M2c. In the example embodiment, the first to third upper wiring lines M1a, M1b, and M1c and the first to third lower wiring lines M2a, M2b, and M2c may extend in the first direction (X-direction).

In the example embodiment, the first to fourth transistors P1, N1, P2, and N2 stacked in order on the substrate 101 may be interconnected by the first and second interconnection structures 210 and 220 and the plurality of upper and lower contact vias 180a, 180b, 180c and 190a, 190b, and 190c connected to the first and second interconnection structures 210 and 220, respectively and may form a NAND circuit illustrated in FIG. 2 (see FIGS. 1 and 3 to 5B).

Referring to FIG. 4 together with FIG. 1, the first gate structure GS1 may be connected to the second lower wiring line M2b through the first lower contact via 190a. The second lower wiring line M2b may be directly connected to the first lower contact via 190a. The first lower contact via 190a may penetrate through the substrate 101 and the device isolation layer 110 and may be in contact with the first gate electrode 145A. Similarly, the second gate structure GS2 may be connected to the second upper wiring line M1b through the first upper contact via 180a. The second upper wiring line M1b may include a second metal via V1b connected to the first upper contact via 180a. The first upper contact via 180a may penetrate through the gate capping layer 147 and may be in contact with the second gate electrode 145B.

As such, referring to FIG. 2, the first gate voltage V1 may be applied to the first gate structure GS1, a shared gate of the first transistor P1 and the second transistor N1, through the second lower wiring line M2b and the first lower contact via 190a, and the second gate voltage V2 may be applied to the second gate structure GS2, a shared gate of the third transistor P2 and the fourth transistor N2, through the second upper wiring line M1b and first upper contact via 180a.

As described hereinabove, the semiconductor device 100 according to the example embodiment may include P-type first and third source/drain patterns 150A1, 150B1, 150A3, and 150B3, and N-type second and fourth source/drain patterns 150A2, 150B2, 150A4, and 150B4. The first to fourth source/drain patterns 150A1, 150A2, 150A3 and 150A4 may be disposed on the first side (e.g., left side in FIG. 3) of the first and second gate structures GS1 and GS2 (see FIG. 5A), and the first to fourth source/drain patterns 150B1, 150B2, 150B3 and 150B4 may be disposed on the second side (e.g., the right side in FIG. 3) of the first and second gate structures GS1 and GS2 (see FIG. 5B).

In the example embodiment, the first to fourth source/drain patterns 150A1, 150A2, 150A3 and 150A4 on the first side and the first to fourth source/drain patterns 150B1, 150B2, 150B3 and 150B4 on the second side may be arranged to overlap each other in the vertical direction (Z-direction). Accordingly, the semiconductor device 100 according to the example embodiment may include contact structures 161A, 162A, 163A, 164A, 161B, 162B, 163B, and 164B connected to the first to fourth source/drain patterns150A1, 150A2, 150A3, 150A4, 150B1, 150B2, 150B3, 150B4, respectively, to be selectively connected to the upper and lower wiring lines M1a, M1b, M1c, M2a, M2b, and M2c and extending in the second direction (Y-direction). In particular, the first and second side contact structures 161A, 162A, 163A, 164A and 161B, 162B, 163B, 164B may extend in difference directions (the forward (right) direction and reverse (left) direction in the second direction (Y-direction)) depending on the positions of the upper and lower wiring lines M1a, M1b, M1c, M2a, M2b, and M2cto be connected. For instance, the first and second side contact structures 161A, 162A, 163A, 164A and 161B, 162B, 163B, 164B may extend in directions parallel to the second direction. For instance, some of the first and second side contact structures 161A, 162A, 163A, 164A and 161B, 162B, 163B, 164B may extend in the second direction or may extend in a direction opposite to the second direction.

For example, referring to FIG. 5A, the first, third and fourth contact structures 161A, 163A, and 164A connected to the first, third and fourth source/drain patterns 150A1, 150A3, and 150A4 on the first side, respectively, may extend in a negative second direction (-Y-direction) (e.g. a direction opposite to the second direction), and the second contact structure 162A connected to the second source/drain pattern 150A2 on the first side may extend in a positive second direction (+Y-direction). Referring to FIG. 5B, the second contact structure 162B connected to the second source/drain pattern 150B2 on the second side may extend in the negative second direction (-Y-direction) (e.g. a direction opposite to the second direction), and the first, third and fourth contact structures 161B, 163B and 164B connected to the first, third and fourth source/drain patterns 150B1, 150B3 and 150B4, respectively, on the second side may extend in the positive second direction (+Y-direction).

Also, at least one contact structure may have a different extension length to the others depending on the positions of the upper and lower wiring lines M1a, M1b, M1c,

M2a, M2b, and M2c to be connected. For example, as illustrated in FIG. 5A, on the first side, the fourth contact structure 164A may have a length different from those of the first to third contact structures 161A, 162A, and 163A. The first lower wiring line M2a and the third lower wiring line M2c may be provided as the first power line PM1 and the second power line PM2, respectively. In the example embodiment, the first and second power lines PM1 and PM2 may be disposed adjacent to both ends of the semiconductor device 100 in the second direction (Y-direction) (or cell height direction) with the active pattern 105 interposed therebetween. The second and third lower contact vias 190b and 190c connected to the first power line PM1 and the second power line PM2, respectively, may be provided as first and second power transfer vias.

The first power line PM1 may be electrically connected to the first and third source/drain patterns 150A1 and 150A3 on the first side through a first power transfer via 190b. In the example embodiment, the first power transfer via 190b may penetrate through the substrate 101 and the device isolation layer 110, may extend to the interlayer insulating layer 120 and may be connected to the first and third contact structures 161A and 163A. On the first side, the first power transfer via 190b may be connected to the first and third source/drain patterns 150A1 and 150A3 on the first side by penetrating through the first contact structure 161A in the interlayer insulating layer 120 and contacting the third contact structure 163A.

Similarly, the second power line PM2 may be electrically connected to the second source/drain pattern 150A2 on the first side through the second power transfer via 190c. In the example embodiment, the second power transfer via 190c may penetrate through the substrate 101 and the device isolation layer 110, may extend to the interlayer insulating layer 120 and may be connected to the second contact structure 162A. On the first side, the second power transfer via 190c may be electrically connected to the second source/drain pattern 150A2 on the first side through the second contact structure 162A in the interlayer insulating layer 120.

As such, referring to FIG. 2, the first power supply VDD may be connected to the first and third source/drain patterns 150A1 and 150A3 on the first side through the first power line PM1 and the first power transfer via 190b, that is, drains of the first and third transistors P1 and P2, respectively. The second power supply VSS may be connected to the second source/drain patterns 150A2 on the first side, that is, the source of second transistor N1, through the second power line PM2 and the second power transfer via 190c.

Referring again to FIG. 5A, the first upper wiring line M1a may be connected to the fourth source/drain pattern 164A on the first side through the second upper contact via 180b. The first upper wiring line M1a may include a first metal via V1a connected to the second upper contact via 180b. On the first side, the second upper contact via 180b may be electrically connected to the fourth source/drain pattern 150A4 on the first side by being in contact with the fourth contact structure 164A in the interlayer insulating layer 120 (in particular, the fourth interlayer insulating film 120d).

Referring again to FIG. 5B, the first upper wiring line M1a may also be electrically connected to the other source/drain patterns on the second side. In particular, the first upper wiring line M1a may be connected to the second source/drain pattern 150B2 on the second side through a third upper contact via 180c, and may include another first metal via V1a' connected to the third upper contact via 180c. The third upper contact via 180c may be connected to the second source/drain pattern 150B2 on the second side by being in contact with the second contact structure 162B on the second side in the interlayer insulating layer 120, such as the second interlayer insulating film 120b.

As described hereinabove, referring to FIG. 2, the fourth source/drain pattern 150A4 on the first side and the second source/drain pattern 150B2 on the second side may be connected to each other through the first upper wiring line M1a and the second and third upper contact vias 180b and 180c. That is, a source of the fourth transistor N2 and a drain of the second transistor N1 may be directly electrically connected to each other.

Referring to FIG. 5B, the third upper wiring line M1c may be connected to the first, third and fourth source/drain patterns 150B1, 150B3, and 150B4 on the second side through a fourth upper contact via 180d. The third upper wiring line M1c may include a third metal via V1c connected to the fourth upper contact via 180d. The fourth upper contact via 180d may penetrate vertically through the third and fourth contact structures 163B and 164B on the second side in the interlayer insulating layer 120 and may be in contact with the first contact structure 161B, so that a direct electrical connection is provided to each of the first, third and fourth source/drain patterns 150B1, 150B3, and 150B4 on the second side. Accordingly, referring again to FIG. 2, the first, third and fourth source/drain patterns 150B1, 150B3, and 150B4 on the second side may be connected to each other through the third upper wiring line M1c and the fourth upper contact via 180d, so that the drain of the first transistor P1, the drain of the third transistor P3, and the drain of the fourth transistor N2 may be directly connected to each other.

Each of the first to fourth contact structures 161A, 162A, 163A, 164A and 161B, 162B, 163B, and 164B on both sides employed in the example embodiment may include a contact plug and a conductive barrier. For example, the contact plug may include Cu, Co, Mo, Ru, W or an alloy thereof. The conductive barrier may include, for example, Ta, TaN, Mn, MnN, WN, Ti, TiN, or a combination thereof.

Each of the plurality of upper and lower contact vias 180a, 180b, 180c and 190a, 190b, and 190c employed in the example embodiment may include a contact plug. For example, the contact plug may include Cu, Co, Mo, Ru, W or an alloy thereof. A plurality of upper and lower contact vias may include a conductive barrier surrounding the contact plug. This conductive barrier may include Ta, TaN, Mn, MnN, WN, Ti, TiN, or a combination thereof, in some embodiments. Since the plurality of lower contact vias penetrate through the substrate, the plurality of lower contact vias may include an insulating barrier to be electrically insulated from the substrate. The insulating barrier may include, for example, SiO₂, SiN, SiCN, SiC, SiCOH, SiON, Al₂O₃, AIN, or a combination thereof.

The first and second wiring insulating layers 211, 212 and 221 employed in the example embodiment may include silicon oxide, silicon oxynitride, SiOC, SiCOH, or a combination thereof. In addition, the upper and lower wiring lines M1a, M1b, M1c, M2a, M2b, and M2c and metal vias V1a, V1a', V1b, and V1c may include copper or a copper-containing alloy. In some example embodiments, the upper wiring lines M1a, M1b, and M1c may be formed together using a dual-damascene process along with the respective metal vias V1a, V1a', V1b, and V1c.

As described hereinabove, in the example embodiment, the first to fourth source/drain patterns 150A1, 150A2, 150A3 and 150A4 on the first side and the first to fourth source/drain patterns 150B1, 150B2, 150B3 and 150B4 on the second side may form a NAND circuit illustrated in FIG. 2 by being selectively connected through the upper and lower wiring lines M1a, M1b, M1c, M2a, M2b, and M2c and the upper and lower contact vias 180a, 180b, 180c, 190a, 190b, and 190c. As such, the semiconductor device according to the example embodiment may be provided as a NAND logic cell.

In the example embodiment, an interconnection structure forming a NAND circuit may be provided, but various circuit structures may be implemented by employing a different interconnection structure in the structure of four field effect transistors (FET) stacked in four stages similarly to the example embodiment. In further embodiments, the plurality of upper contact vias may be configured to electrically connect each of the plurality of upper wiring lines to at least one of first to fourth source/drain patterns on one side (the first side or the second side). To implement more complex and diverse circuits, at least one of the plurality of upper contact vias (e.g., fourth upper contact via 180d) may be connected to two or more source/drain patterns on one side, that is, two or more contact structures on one side.

Similarly, the plurality of lower contact vias may be configured to electrically connect each of the plurality of lower wiring lines to at least one of first to fourth source/drain patterns on either side (the first side or the second side). To implement more complex and diverse circuits, at least one of the plurality of lower contact vias (e.g., second lower contact via 190b) may be connected to two or more source/drain patterns on one side, that is, two or more contact structures on one side.

Also, as in the example embodiment, when the first shared gate structure (e.g., GS1) of the lower two-stage transistors and the second shared gate structure (e.g., GS2) of the upper two-stage transistors are isolated from each other, the first and the second shared gate structure may be configured such that gate voltages (e.g., V1, V2) may be applied through upper wiring lines and lower wiring lines, respectively. In this case, the lower wiring line may be connected by a lower contact via penetrating through the substrate.

As in the example embodiment, power may be supplied through a second interconnection structure disposed below the substrate. A first power supply VDD and a second power supply VSS may be connected to at least one source/drain pattern, that is, at least one contact structure, through the first power transfer via and the second power transfer via, respectively, to supply necessary power.

In the example embodiment, a plurality of upper wiring lines may include first to third upper wiring lines M1a, M1b, and M1c each extending in the first direction (X-direction). In plan view (see FIGS. 1, 5A and 5B), the first and second upper wiring lines M1a and M1b may be disposed to be isolated from a third upper wiring line M1c with the active pattern 105 interposed therebetween. Similarly, the plurality of lower wiring lines may include a first lower wiring line M2a (first power line PM1), a second lower wiring line M2b, and a third lower wiring line M2c (second power line PM2) extending in the first direction (X-direction), respectively. In plan view (see FIGS. 1, 5A and 5B), the first power line PM1 may be disposed to be isolated from the second lower wiring line M2b and the second power line PM2 with the active pattern 105 interposed therebetween.

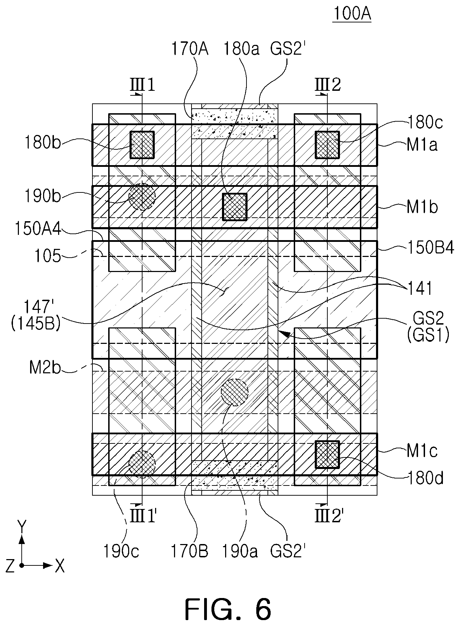

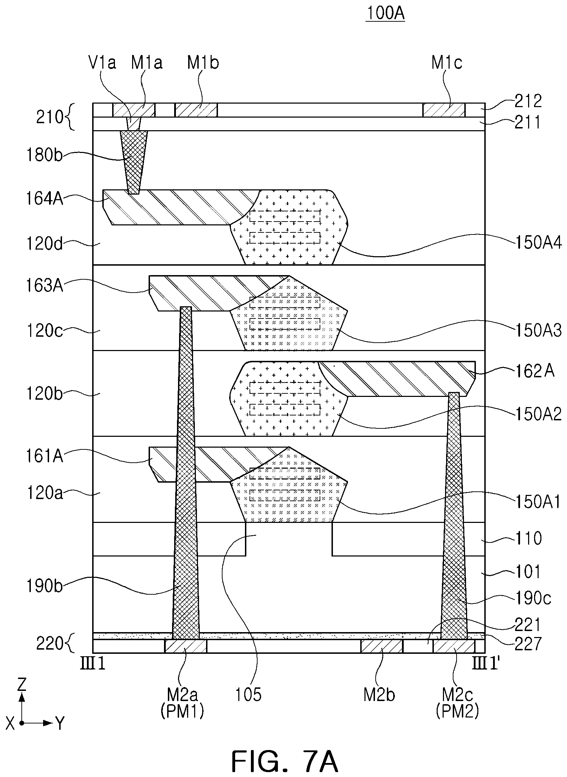

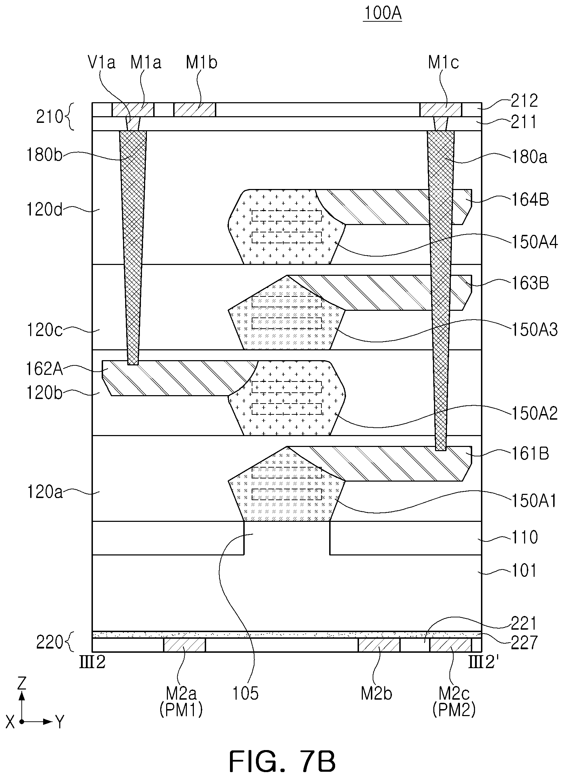

However, an example embodiment thereof is not limited thereto, and the plurality of upper wiring lines and the plurality of lower wiring lines may be arranged in various manners by being spaced apart from each other in the second direction (Y-direction) in both sides regions with respect to the active pattern. A semiconductor device 100A implementing the same circuit as the circuit illustrated in FIG. 2 may also have a different arrangement as illustrated in FIGS. 6, 7A and 7B.

FIG. 6 is a plan diagram illustrating a semiconductor device according to an example embodiment. FIGS. 7A and 7B are cross-sectional diagrams illustrating the semiconductor device illustrated in FIG. 6 taken along lines III1-III1' and III2-III2'. Referring now to FIGS. 6, 7A and 7B, the semiconductor device 100A according to the example embodiment may have a structure similar to the structure to the semiconductor device 100 illustrated in FIGS. 1 to 5A and 5B, other than the arrangement of the plurality of lower wiring lines M2a, M2b, and M2c and the configuration of the portion 161A and 163A of the contact structure. Also, the components in the example embodiment may be understood by referring to the descriptions of the same or similar components of the semiconductor device 100 illustrated in FIGS. 1 to 5A and 5B unless otherwise indicated.

In the plurality of lower wiring lines, the first lower wiring line M2a (first power line PM1) may be disposed closer to the active pattern than the third lower wiring line M2c (second power line PM2). In this arrangement, as illustrated in FIG. 7A, the contact structures 161A and 163A on the first side connected to the first power line PM1 may have an extended length smaller than that of the other contact structures 164A. As such, the semiconductor device 100A according to the example embodiment may have a width (a cell height) smaller than a width of the semiconductor device 100 in the second direction (Y-direction) according to the aforementioned example embodiment.

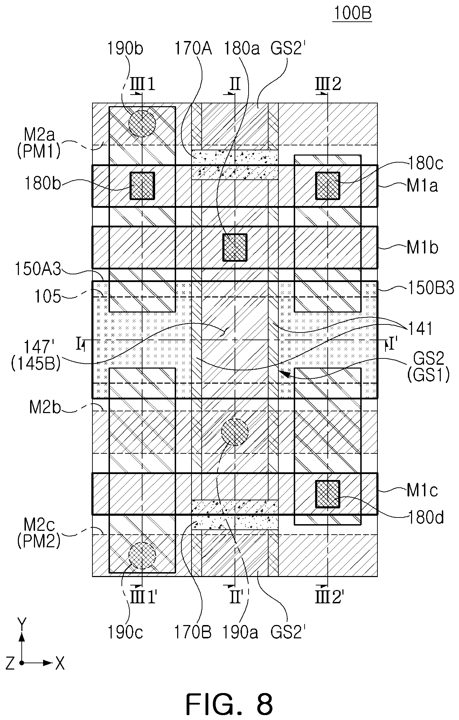

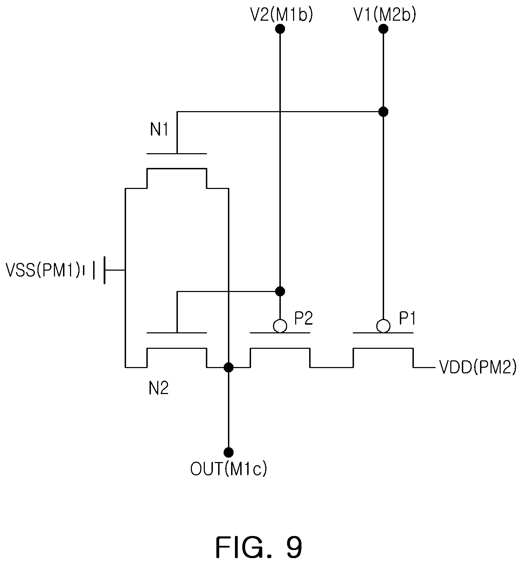

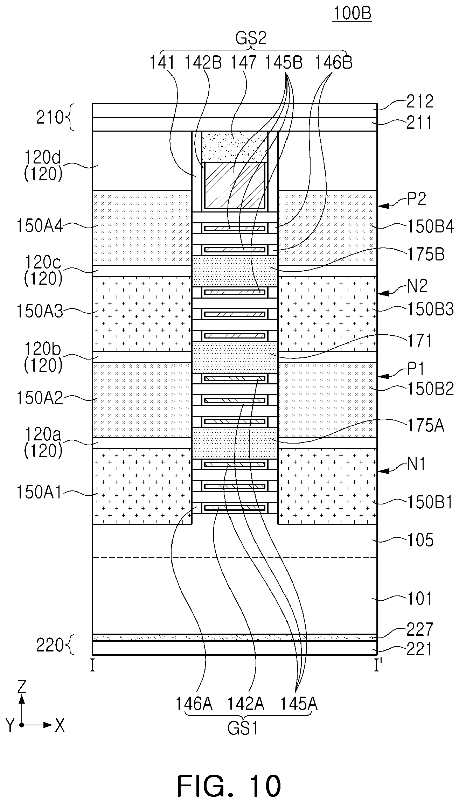

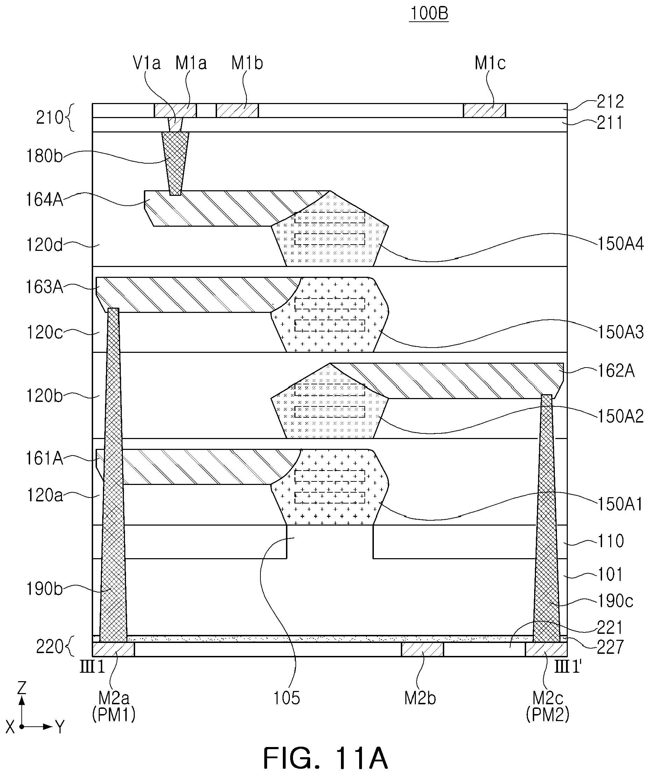

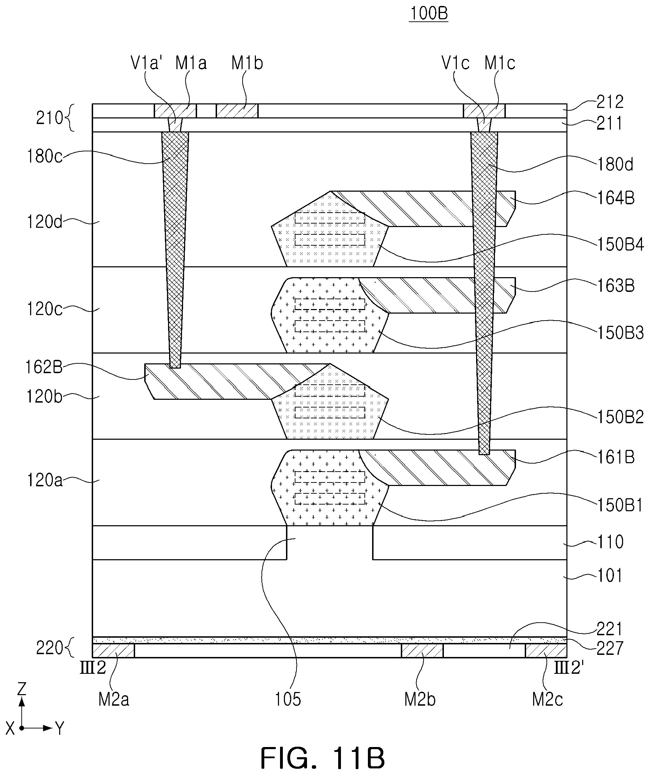

FIG. 8 is a plan diagram illustrating a semiconductor device according to an example embodiment. FIG. 9 is an equivalent circuit diagram illustrating the semiconductor device illustrated in FIG. 8. FIG. 10 is a cross-sectional diagram illustrating the semiconductor device illustrated in FIG. 8 taken along line I-I'. FIGS. 11A and 11B are cross-sectional diagrams illustrating the semiconductor device illustrated in FIG. 8 taken along lines III1-III1' and III2-III2'.

Referring to FIGS. 8, 9, 10, 11A and 11B, the semiconductor device 100B according to the example embodiment may have a structure similar to the semiconductor device 100 illustrated in FIGS. 1 to 5A and 5B other than the configuration in which a stacking order of the first to fourth transistors is different, in order to implement the NOR circuit illustrated in FIG. 9 (instead of the NAND circuit illustrated in FIG. 2). Also, the components in the example embodiment may be understood by referring to the descriptions of the same or similar components of the semiconductor device 100 illustrated in FIGS. 1 to 5A and 5B unless otherwise indicated.

Referring to FIG. 10, the semiconductor device 100B according to the example embodiment may include first to fourth transistors N1, P1, N2, and P2 stacked and spaced apart from each other in a direction (Z-direction) perpendicular to an upper surface of the substrate 101. In the example embodiment, each of the first and third transistors N1 and N2 may be configured as an N-type MOSFET, and each of the second and fourth transistors P1 and P2 may be configured as a P-type MOSFET. That is, the first source/drain patterns 150A1, 150B1 and the third source/drain patterns 150A3 and 150B3 may be formed as N-type source/drain regions, and the second source/drain patterns 150A2, 150B2 and the fourth source/drain patterns 150A4 and 150B4 may be formed as P-type source/drain regions.

In the example embodiment, the first to fourth transistors N1, P1, N2, and P2 stacked in order on the substrate 101 may be interconnected to the first and second interconnection structures 210 and 220 by a plurality of upper and lower contact vias 180a, 180b, 180c, 190a, 190b, and 190c connected to the first and second interconnection structures 210 and 220, respectively, and may form the NOR circuit illustrated in FIG. 9 (see FIGS. 8, 9, 10, 11A and 11B).

Similarly to the aforementioned example embodiment (see FIG. 4), the first gate structure GS1 may be connected to the second lower wiring line M2b through the first lower contact via 190a penetrating through the substrate 101 and the device isolation layer 110. Similarly, the second gate structure GS2 may be connected to the second upper wiring line M1b through the first upper contact via 180a.

As such, a first gate voltage V1 may be applied to first gate structure GS1, a shared gate of the first transistor N1 and the second transistor P1, through the second lower wiring line M2b and the first lower contact via 190a, and a second gate voltage V2 may be applied to a second gate structure GS2, a shared gate of the third transistor N2 and the fourth transistor P2, through the second upper wiring line M1b and the first upper contact via 180a (see FIG. 9).

Referring to FIG. 11A, the first power transfer via 190b may penetrate through the first contact structure 161A on the first side in the interlayer insulating layer 120 and may be in contact with the third contact structures 163A on the first side, such that the first power line PM1 may be electrically connected to the first and third source/drain patterns 150A1 and 150A3 on the first side. Similarly, the second power transfer via 190c may penetrate through the substrate 101 and the device isolation layer 110, may extend to the interlayer insulating layer 120, and may be connected to the second contact structure 162A, such that the second power line PM2 may be electrically connected to the second source/drain pattern 150A2 on the first side.

As such, the first power supply VDD may be connected to a source of the second transistor P1 through the second power line PM2 and the second power transfer via 190c. The second power supply VSS may be connected to sources of the first and third transistors N1 and N2 through the first power line PM1 and the first power transfer via 190b, respectively (see FIG. 9).

Referring to FIG. 11A, the second upper contact via 180b may be in contact with the fourth contact structure 164A on the first side in the interlayer insulating layer (in particular, the fourth interlayer insulating film 120d), such that the first upper wiring line M1a on the first side may be electrically connected to the fourth source/drain pattern 150A4. Referring to FIG. 11B, the third upper contact via 180c may be in contact with the second contact structure 162B on the second side in the interlayer insulating layer (in particular, the second interlayer insulating film 120b), such that the first upper wiring line M1a may be electrically connected to the second source/drain pattern 150B2 of the second side.

The first upper wiring line M1a may be in connect with the fourth source/drain pattern 150A4 on the first side and the second source/drain pattern 150B2 on the second side. That is, the source of the fourth transistor P2 and the drain of the second transistor P1 may be directly connected to each other (see FIG. 9).

Referring to FIG. 11B, the fourth upper contact via 180d may penetrate through the third and fourth contact structures 163B and 164B on the second side in the interlayer insulating layer 120 and may be in contact with the first contact structure 161B, such that the third upper wiring line M1c may be electrically connected to each of the first, third and fourth source/drain patterns 150B1, 150B3, and 150B4 on the second side. As such, the drain of the first transistor N1, the drain of the third transistor N2, and the drain of the fourth transistor P2 may be directly connected to each other (see FIG. 9).

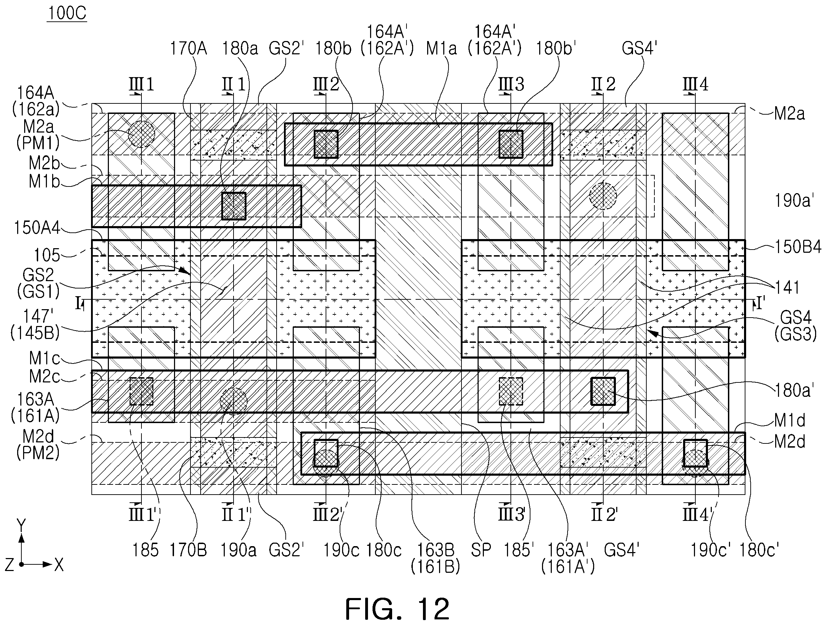

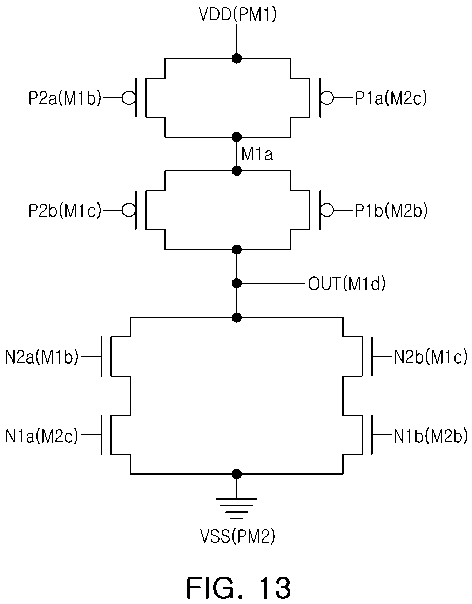

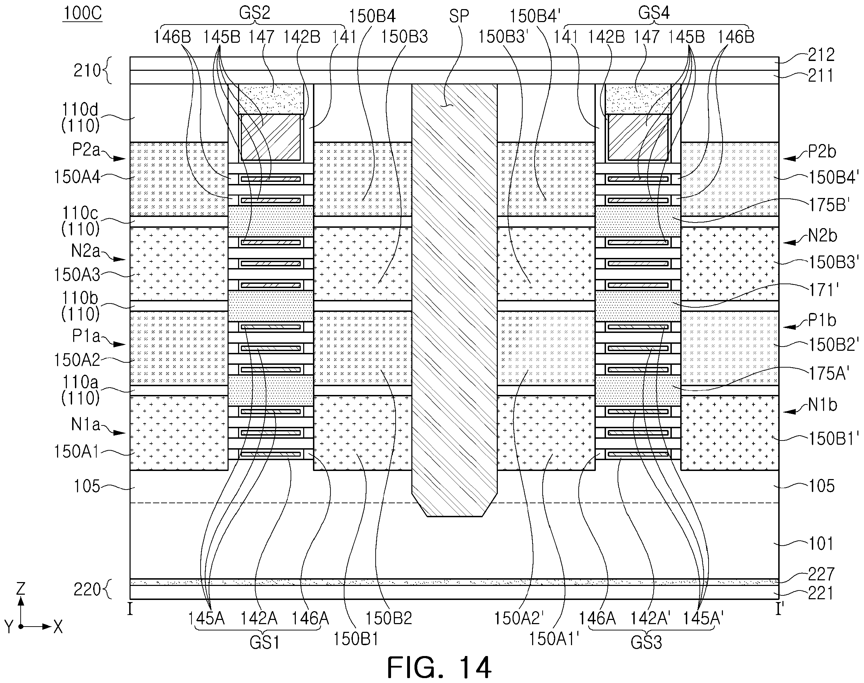

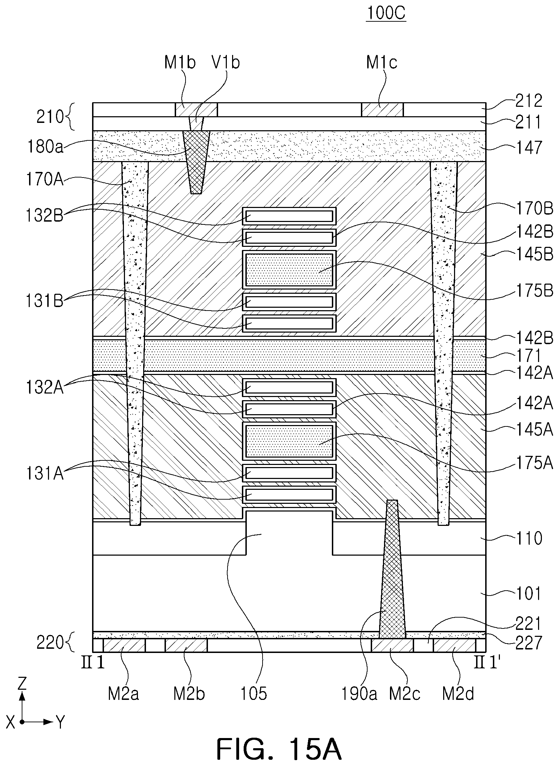

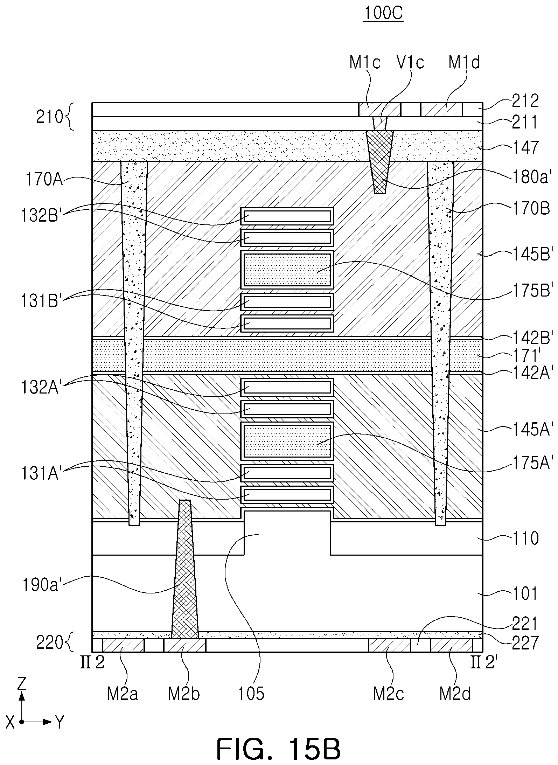

FIG. 12 is a plan diagram illustrating a semiconductor device according to an example embodiment. FIG. 13 is an equivalent circuit diagram illustrating the semiconductor device illustrated in FIG. 12. FIG. 14 is a cross-sectional diagram illustrating the semiconductor device illustrated in FIG. 12 taken along line I-I'. FIGS. 15A and 15B are cross-sectional diagrams illustrating the semiconductor device illustrated in FIG. 12 taken along lines II1-II1' and II2-II2'.

Referring to FIGS. 12, 13, 14, 15A and 15B, a semiconductor device 100C according to the example embodiment may include a substrate 101 having a first region and a second region, first to fourth transistors N1a, P1a, N2a, P2a stacked in order on the first region of the substrate 101, and fifth to eighth transistors N1b, P1b, N2b, P2b stacked in order on the second region of the substrate 101. In the example embodiment, a first region (left region) and a second region (right region) may be isolated from each other by a device isolation structure SP extending in a second direction (Y-direction). Here, the components in the example embodiment may be understood with reference to the descriptions of the same or similar components of the semiconductor device 100 illustrated in FIGS. 1 to 5A and 5B unless otherwise indicated.

The first to eighth transistors N1a, P1a, N2a, P2a, N1b, P1b, N2b, and P2b employed in the example embodiment may be interconnected to each other by a plurality of upper and lower wiring lines M1a, M1b, M1c, M1d, M2a, M2b, M2c, and M2d, a plurality of upper contact vias 180a, 180b, 180c, 180a', 180b', and 180c' and a plurality of lower contact vias 190a, 190b, 190c, 190a', 190b', and 190c'. The interconnection structure employed in the example embodiment may further include first and second interconnecting vias 185 and 185' connecting contact structures in the interlayer insulating portion 120 to each other.

As illustrated in FIG. 13, the transistors N1a, P1a, N2a, P2a, N1b, P1b, N2b, and P2b may implement AOI22 (2-2 AND-OR-invert) circuits by the aforementioned interconnection structures, and the semiconductor device according to the example embodiment may be provided as an AOI22 logic cell. Here, in the example embodiment, each of the first, third, fifth and seventh transistors N1a, N2a, N1b, and N2b may be configured as an N-type MOSFET, and each of the second, fourth, sixth and eighth transistors P1a, P2a, P1b, and P2b may be configured as a P-type MOSFET.

Referring to FIGS. 14, 15A and 15B, the first to fourth channel structures may be stacked in order on one region of an active pattern 105 in a first region of a substrate 101. The first to fourth channel structures may include a plurality of first to fourth semiconductor patterns 131A, 132A, 131B, and 132B stacked and spaced apart from each other in a vertical direction (Z-direction). Similarly, a plurality of fifth to eighth semiconductor patterns 131A', 132A', 131B', and 132B' stacked and spaced apart from each other in the vertical direction (Z-direction) on one region of the active pattern 105 in the second region of the substrate 101 may be further included.

A first intermediate insulating pattern 175A may be disposed between the plurality of first semiconductor patterns 131A and the plurality of second semiconductor patterns 132A, and a second intermediate insulating pattern 175B may be disposed between the plurality of third semiconductor patterns 131B and the plurality of fourth semiconductor patterns 132B. Similarly, a third intermediate insulating pattern 175A' may be disposed between the plurality of fifth semiconductor patterns 131A' and the plurality of sixth semiconductor patterns 132A', and a fourth intermediate insulating pattern 175B' may be disposed between the plurality of seventh semiconductor patterns 131B' and the plurality of eighth semiconductor patterns 132B'.

In the first region, the first and second transistors N1a and P1a may include a first gate structure GS1 extending in the second direction (Y-direction) as a shared gate, and the third and fourth transistors N2a and P2a may include a second gate structure GS2 extending in the second direction (Y-direction) as a shared gate. The first inter-gate insulating layer 171 may be disposed between the first gate structure GS1 and the second gate structure GS2. Similarly, in the second region, the fifth and sixth transistors N1b and P1b may include a third gate structure GS3 extending in the second direction (Y-direction) as a shared gate, and the seventh and eighth transistors N2b and P2b may include a fourth gate structure GS4 extending in the second direction (Y-direction) as a shared gate. The second inter-gate insulating layer 171' may be disposed between the third gate structure GS3 and the fourth gate structure GS4.

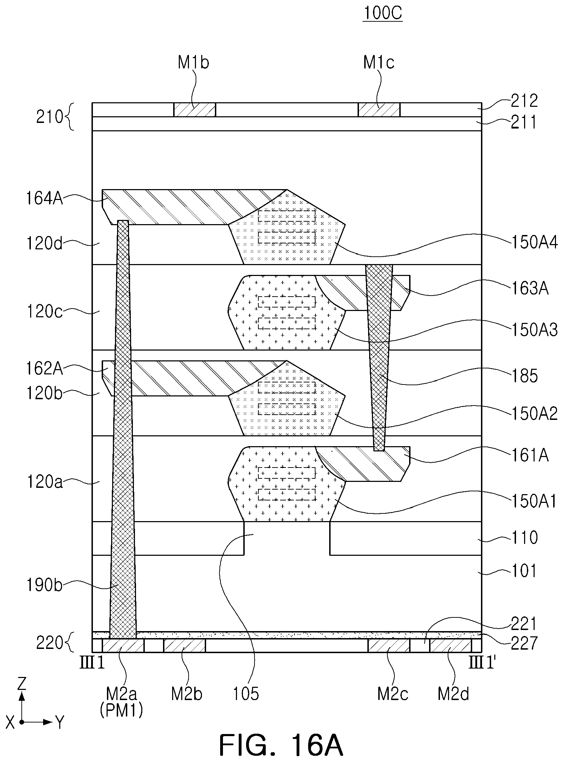

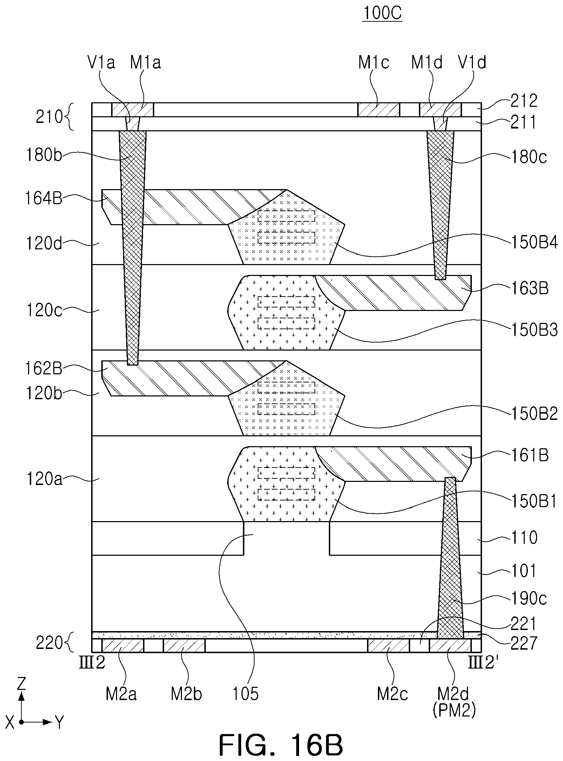

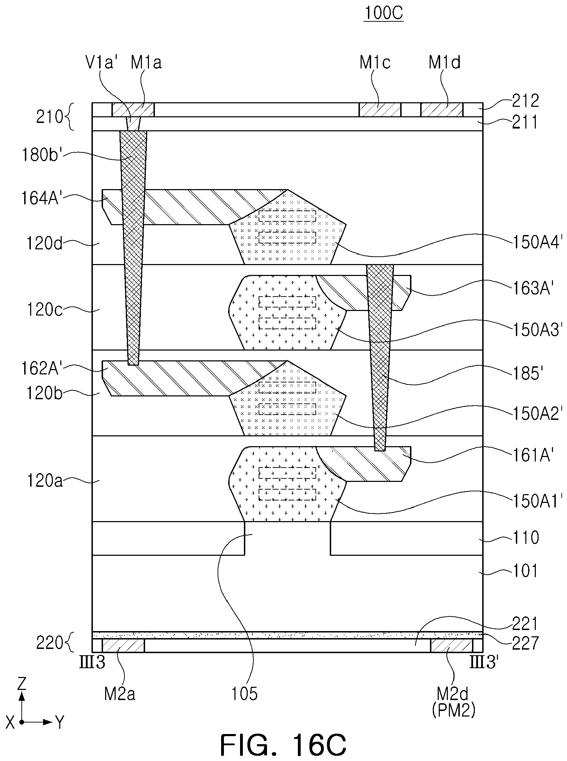

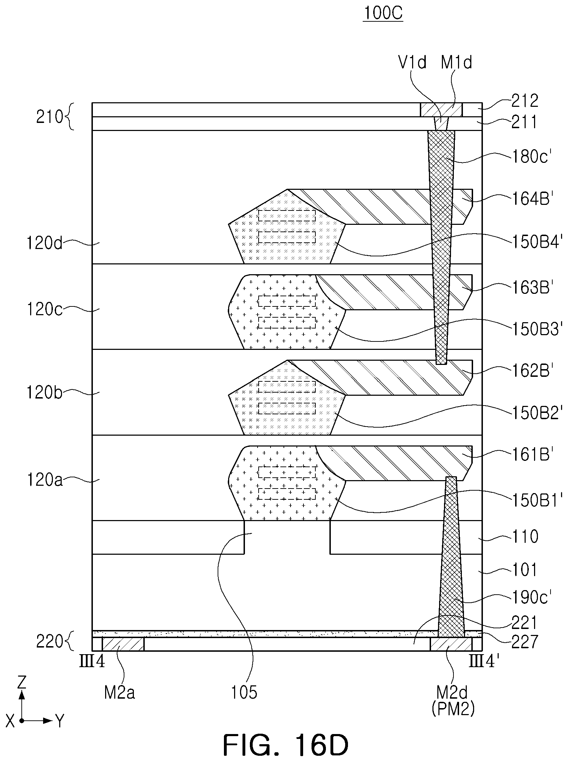

FIGS. 16A to 16D are cross-sectional diagrams illustrating the semiconductor device illustrated in FIG. 12 taken along lines III1-III1', III2-III2', III3-III3' and III4-III4'. Here, FIGS. 16A and 16B illustrate both sides (also referred to as "first side" and "second side, " respectively) of the first and second gate structures GS1 and GS2, respectively, and FIGS. 16C and 16D illustrate both sides (also referred to as "third side" and "fourth side" respectively) of the third and fourth gate structures GS3 and GS4, respectively.

Referring to FIGS. 16A and 16B together with FIG. 14, the first and second transistors N1a and P1a may further include a pair of connected first and second source/drain patterns 150A1, 150B1 and 150A2, 150B2 connected to both ends of the plurality of first and second semiconductor patterns 131A and 132A on both sides of the first gate structure GS1, respectively, and the third and fourth transistors N2a, P2a may further include a pair of third and fourth source/drain patterns 150A3, 150B3, 150A4, and 150B4 connected to both ends of a plurality of third and fourth semiconductor patterns 131B and 132B, respectively, on both sides of the second gate structure GS2.

Similarly, referring to FIGS. 16C and 16D together with FIG. 14, the fifth and sixth transistors N1b and P1b may further include a pair of fifth and sixth source/drain patterns 150A1', 150B1' and 150A2', 150B2' respectively connected to both ends of a plurality of fifth and sixth semiconductor patterns 131A' and 132A' on both sides of the third gate structure GS3, respectively, and the seventh and eighth transistors N2b and P2b may further include a pair of seventh and eighth source/drain patterns 150A3', 150B3' 150A4', and 150B4' connected to both ends of a plurality of seventh and eighth semiconductor patterns 131B' and 132B', respectively, both sides of the fourth gate structure GS4.

In the example embodiment, the first source/drain patterns 150A1, 150B1, the third source/drain patterns 150A3 and 150B3, the fifth source/drain patterns 150A1', 150B1' and the seventh source/drain patterns 150A3', 150B3' may be formed by N-type source/drain region, and the second source/drain patterns 150A2, 150B2, the fourth source/drain patterns 150A4, 150B4, the sixth source/drain patterns 150A2', 150B2' and the eighth source/drain patterns 150A4', 150B4' may be formed as P-type source/drain regions.

The interconnection structure of the semiconductor device 100C according to the example embodiment will be described in greater detail with reference to FIGS. 16A to 16D together with FIGS. 12 to 15B. First, referring to FIG. 15A, a first gate electrode 145A may be connected to a third lower wiring line M2c through a first lower contact via 190a penetrating through the substrate 101 and the device isolation layer 110, and the second gate electrode 145B may be connected to the second upper wiring line M1b through the first upper contact via 180a. Similarly, referring to FIG. 15B, the third gate electrode 145A' may be connected to the second lower wiring line M2b through the fifth lower contact via 190a' penetrating through the substrate 101 and the device isolation layer 110, and the fourth gate electrode 145B' may be connected to the third upper wiring line M1c through the fifth upper contact via 180a'.

As such, the first gate voltage may be applied to the first gate electrode 145A, the shared gate of the first transistor N1a and the second transistor P1a, through the third lower wiring line M2c, and the second gate voltage is applied to the third transistor N2a through the second upper wiring line M1b, and the second gate voltage may be applied to the second gate electrode 145B, the shared gate of the third transistor N2a and the fourth transistor P2a, through the second upper wiring line M1b (see FIG. 13). Also, the third gate voltage may be applied to third gate electrode 145A', the shared gate of the fifth transistor N1b and the sixth transistor P1b, through the second lower wiring line M2b, and the fourth gate voltage may be applied to the fourth gate electrode 145B', the shared gate of the seventh transistor N2b and the eighth transistor P2b, through the third upper wiring line M1c (see FIG. 13).

The plurality of lower wiring lines may include first and second power lines PM1 (M2a) and PM2 (M2d). In plan view (see FIGS. 12 and 16A to 16D), the second power line PM2 may be arranged to be isolated from the second lower wiring line M2b and the first power line PM1 with the active pattern 105 interposed therebetween.

Referring to FIGS. 16A, 16B, and 16D, the first lower wiring line M2a and the fourth lower wiring line M2d may be provided as a first power line PM1 and a second power line PM2, respectively. The second lower contact via 190b and the two third lower contact vias 190c and 190c' connected to the first and second power lines PM1 and PM2, respectively, may be provided as a first power transfer via and second power transfer vias.

Referring to FIG. 16A, the first power line PM1 may be electrically connected to the second and fourth source/drain patterns 150A2 and 150A4 on the first side of the first and second gate structures GS1 and GS2 through the first power transfer via 190b. In the example embodiment, the first power transfer via 190b may penetrate through the substrate 101 and the device isolation layer 110, may extend to the interlayer insulating layer 120 and may be connected to the second and fourth contact structures 162A and 164A on the first side. The first power transfer via 190b may penetrate through the second contact structure 162A on the first side in the interlayer insulating layer 120, may be in contact with the fourth contact structures 164A on the first side, thereby electrically connecting the first power line PM1 to the second and fourth source/drain patterns 150A2 and 150A4 on the first side.

Similarly, referring to FIGS. 16B and 16D, the second power line PM2 may be electrically connected to the first source/drain pattern 150B1 on the second side through one second power transfer via 190c, and may be electrically connected to the fifth source/drain pattern 150B1' on the second side through another second power transfer via 190c'. In the example embodiment, the two second power transfer vias 190c and 190c' may penetrate through the substrate 101 and the device isolation layer 110, may extend to the interlayer insulating layer 120 and may be connected to the first contact structure 161B of the second side and the fifth contact structure 161B' of the fourth side. The two second power transfer vias 190c and 190c' may be in contact with the first contact structure 161B of the second side and the fifth contact structure 161B' of the fourth side in the interlayer insulating layer 120, thereby electrically connecting the second power line PM2 to the first source/drain pattern 150B1 on the second side and the fifth source/drain pattern 150B1' on the fourth side.

As described hereinabove, referring to FIG. 13, the first power supply VDD may be connected to the second and fourth source/drain patterns 150A2 and 150A4 on the first side, that is, the sources of the second and fourth transistors P1a and P2a, respectively, through the first power line PM1 and the first power transfer via 190b. The second power supply VSS may be connected to first source/drain patterns 150B1 on the second side and fifth source/drain pattern 150B1' on the fourth side, that is, the sources of first transistor N1a and fifth transistor N1b, through the second power line PM2 and two second power transfer vias 190c and 190c'.

Referring to FIGS. 16B and 16C, the first upper wiring line M1a may be connected to the second and fourth source/drain patterns 150B2 and 150B4 on the second side through one second upper contact via 180b, and may be connected to the sixth and eighth source/drain patterns 150A2' and 150A4' on the third side via another second upper contact via 180b'. The first upper wiring line M1a may include two first metal vias V1a and V1a' connected to two second upper contact vias 180b and 180b', respectively. The second upper contact vias 180b and 180b' may be in contact with the second and fourth contact structures 162B and 164B on the second side and the sixth and eighth contact structures 162A' and 164A' on the third side in the interlayer insulating layer 120, respectively, such that the first upper wiring line M1a may electrically connect the second and fourth source/drain patterns 150B2 and 150B4 of the second side and the sixth and the eighth source/drain patterns 150A2' and 150A4' on the third side to each other.

As such, referring to FIG. 13, on the second side, the second and fourth source/drain patterns 150B2 and 150B4 on the second side may be electrically connected to each other through the second upper contact via 180b, such that the drain of the second transistor P1a and the drain of the fourth transistor P2a may be connected to each other. Similarly, on the third side, the sixth and eighth source/drain patterns 150A2' and 150A4' on the third side may be electrically connected to each other through another second upper contact via 180b' such that the source of the sixth transistor P1b and the source of the eighth transistor P2b may be connected to each other. Also, the drain of the second transistor P1a, the drain of the fourth transistor P2a, the source of the sixth transistor P1b, and the source of the eighth transistor P2b may be connected to each other by the first upper wiring line M1a.

Referring to FIGS. 16B and 16D, the fourth upper wiring line M1d may be connected to the third source/drain pattern 150B3 on the second side through one third upper contact via 180c, and may be connected to the sixth, seventh and eighth source/drain patterns 150B2', 150B3', 150B4' of the fourth side through another third upper contact via 180c'. The fourth upper wiring line M1d may include two fourth metal vias V1d and V1d' connected to two third upper contact vias 180c and 180c', respectively. The two third upper contact vias 180c and 180c' may be in contact with the third contact structures 163B on the second side and the sixth to eighth contact structures 162B', 163B', and 164B' of the fourth side, respectively, in the interlayer insulating layer 120, such that the fourth upper wiring line M1d may connect the third source/drain pattern 150B3 of the second side and the sixth to eighth source/drain patterns 150B2', 150B3', 150B4' of the fourth side to each other.

As such, referring to FIG. 13, the drains of the third and seventh transistors N2a and N2b and the drains of the sixth and eighth transistors P1b and P2b may be connected to each other through the fourth upper wiring line M1d and two third upper contact vias 180c and 180c'. Also, the fourth upper wiring line may be provided as an output (OUT) line.

The semiconductor device 100C according to the example embodiment may further include first and second interconnecting vias 185 and 185' for connecting two or more contact structures to each other among contact structures on one side in the interlayer insulating layer 120.

Referring to FIG. 16A, a first interconnecting via 185 may electrically connect the first and third source/drain patterns 150A1 and 150A3 to each other on the first side by interconnecting first and third contact structures 161A and 163A on the first side. The first interconnecting via 185 may pass through the second and third interlayer insulating films 120b and 120c to penetrate through the third contact structure 163A on the first side, may extend to the first interlayer insulating film 120a, such that the first interconnecting via 185 may also be in contact with the first contact structure 161A on the first side.

Also, referring to FIG. 16C, the second interconnecting via 185' may interconnect the fifth and seventh contact structures 161A' and 163A' on the third side, thereby electrically connecting the fifth and seventh source/drain patterns 150A1' and 150A3' on the third side. The second interconnecting via 185' may pass through the second and third interlayer insulating films 120b and 120c to penetrate through the seventh contact structure 163A' on the third side and may extend to the first interlayer insulating film 120a, such that the second interconnecting via 185' may also be in contact with the fifth contact structure 161A' on the third side.

Referring to FIG. 13, the drain of the first transistor N1a and the source of the third transistor N2a may be directly connected to each other through the first interconnecting via 185, and the drain of the fifth transistor N1b and the source of the seventh transistor N2b may be directly connected to each other through the second interconnecting via 185'.

By implementing the interconnection structure described above, the first to fourth transistors N1a, P1a, N2a, and P2a stacked in the first region and the fifth to eighth transistors N1b, P1b, N2b, and P2b stacked in the second region may the form circuit illustrated in FIG. 13. As such, the semiconductor device according to the example embodiment may implement various circuits through an interconnection structure including contact structures, contact vias, and wiring lines. Also, the interconnection structure between devices may be simplified by arranging a power line and/or some signal lines among wiring lines on the lower surface of the substrate and connecting the components to a desired device (e.g., transistor) through contact vias penetrating through the substrate.

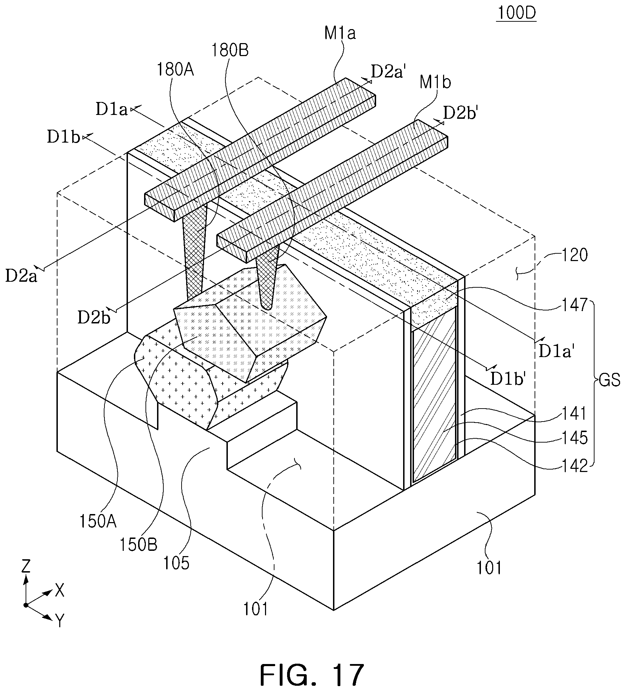

In some example embodiments, the entirety or a portion of the contact structure may not be provided and the contact via may be directly connected to the source/drain patterns, or the contact structure may be further simplified (e.g., shortening the extension length). The semiconductor devices described above are illustrated in FIGS. 17 to 19B.

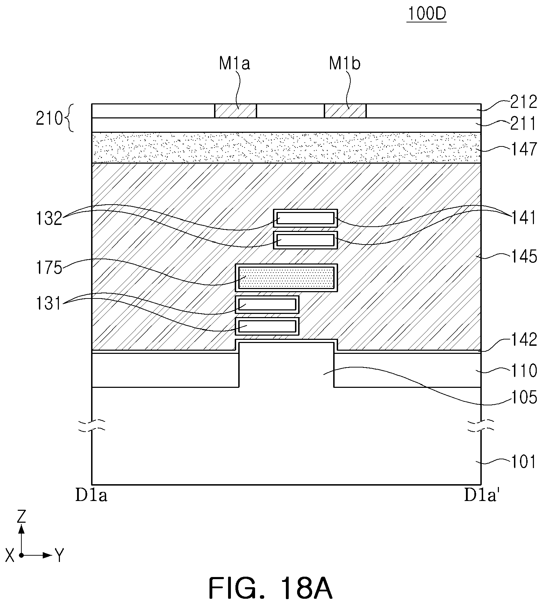

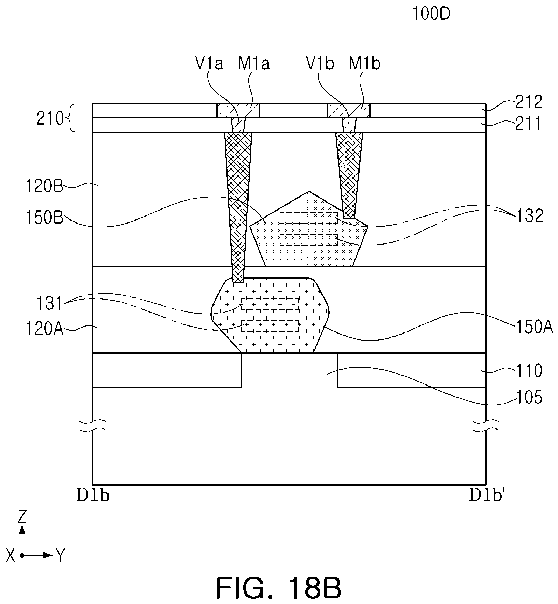

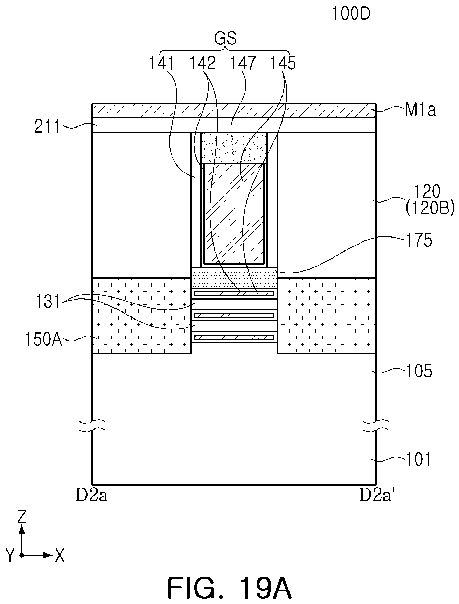

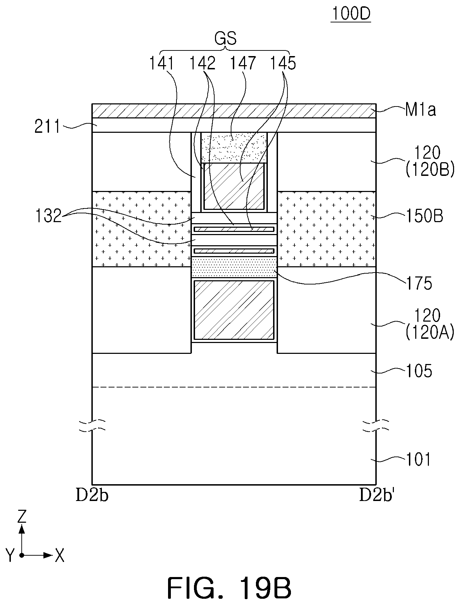

FIG. 17 is a perspective diagram illustrating a semiconductor device according to an example embodiment. FIGS. 18A and 18B are cross-sectional diagrams illustrating the semiconductor device illustrated in FIG. 17 taken along lines D1a-D1a' and D1b-D1b'. FIGS. 19A and 19B are cross-sectional diagrams illustrating the semiconductor device illustrated in FIG. 17 taken along lines D2a-D2a' and D2b-D2b'.

Referring to FIGS. 17, 18A, and 18B, a semiconductor device 100D according to the example embodiment may include an active pattern 105 extending in a first direction (X-direction) on a substrate 101, a plurality of first semiconductor patterns 131 stacked and spaced apart from each other in a direction perpendicular to one region of the active pattern 105 (Z-direction), a plurality of second semiconductor patterns 132 stacked and spaced apart from each other on a plurality of first semiconductor patterns 131 in the vertical direction (Z-direction), and a gate structure GS crossing the one region of the active pattern, extending in a second direction (Y-direction) and surrounding the plurality of first semiconductor patterns 131 and the plurality of second semiconductor patterns 132. The plurality of first and second semiconductor patterns 131 and 132 may be provided as first and second channel structures, respectively. The semiconductor device 100D may further include an intermediate insulating pattern 175 disposed between the first channel structure and the second channel structure.

Also, components in the example embodiment may be understood by referring to descriptions of the same or similar components of the semiconductor device 100 illustrated in FIGS. 1 to 5A and 5B unless otherwise indicated. As illustrated in FIG. 18A, in a cross-sectional plane in the second direction (Y-direction), the plurality of first semiconductor patterns 131 may partially overlap the plurality of second semiconductor patterns 132 in the vertical direction (Z-direction). In the example embodiment, the plurality of first and second semiconductor patterns 131 and 132 may have a width smaller than that of the intermediate insulating pattern 175, left edges of the plurality of first semiconductor patterns 131 may be arranged to be parallel to (e.g. aligned with) the left edge of the intermediate insulating pattern 175 in the Z-direction, and right edges of the plurality of second semiconductor patterns 132 may be arranged to be parallel to (e.g. aligned with) right edges of intermediate insulating pattern 175 in the Z-direction. Accordingly, in the vertical direction (Z-direction), a partial region on the left of the plurality of first semiconductor patterns 131 may not overlap the plurality of second semiconductor patterns 132, and a partial region on the right of the plurality of second semiconductor patterns 132 may not overlap the plurality of first semiconductor patterns 131. The term "overlap" (or "overlapping", or like terms), as may be used herein, is intended to broadly refer to a first element that intersects with at least a portion of a second element when viewed in a particular direction (e.g. in the vertical direction) but does not require that the first and second elements be completely aligned with one another; that is, components or layers described with reference to "overlap" in a particular direction may be at least partially obstructed by one another when viewed along a line extending in the particular direction.

Similarly, as illustrated in FIG. 18B, the first source/drain pattern 150A connected to the plurality of first semiconductor patterns 131 and the second source/drain pattern 150B connected to the plurality of second semiconductor patterns 132 may also have regions not overlapping each other in the Z-direction (e.g. may only partially overlap). As such, the semiconductor device 100D according to the example embodiment may have a structure in which two transistors are stacked, or may have a region in which first and second source/drain patterns 150A and 150B do not overlap. Accordingly, in the example embodiment, the transistors (first and second source/drain patterns) may be connected to the wiring lines M1a and M1b only with the contact vias 180A and 180B extending in the vertical direction (Z-direction) without a contact structure, respectively.

Specifically, as illustrated in FIGS. 17 and 18B, the first upper contact via 180A connected to the first upper wiring line M1a may be in contact with a non-overlapping region of the first source/drain pattern 150A. The second upper contact via 180B connected to the second upper wiring line M1b may be in contact with a region (e.g., non-overlapping region) of the second source/drain pattern 150B to be sufficiently spaced from the first upper contact via 180A.

In the example embodiment, the connection with the upper wiring line is implemented, but the lower wiring line may also be similarly connected. That is, the lower contact via connected to the lower wiring line may penetrate through the substrate 101 and may be in contact with a non-overlapping region of the second source/drain pattern 150B.

FIGS. 19A and 19B illustrate cross-sectional surfaces in a first direction (X-direction) in regions in which the plurality of first semiconductor patterns 131 and the plurality of second semiconductor patterns 132 do not overlap in the vertical direction, respectively. Referring to FIG. 19A, instead of the plurality of second semiconductor patterns 132, a structure in which a gate structure GS extends downwardly to an upper surface of an intermediate insulating pattern 175 may be disposed above the plurality of first semiconductor patterns 131. Referring to FIG. 19B, instead of the plurality of first semiconductor patterns 131, a structure in which the gate structure GS is filled between an intermediate insulating pattern 175 and an active pattern 105 may be disposed below the plurality of second semiconductor patterns 132.

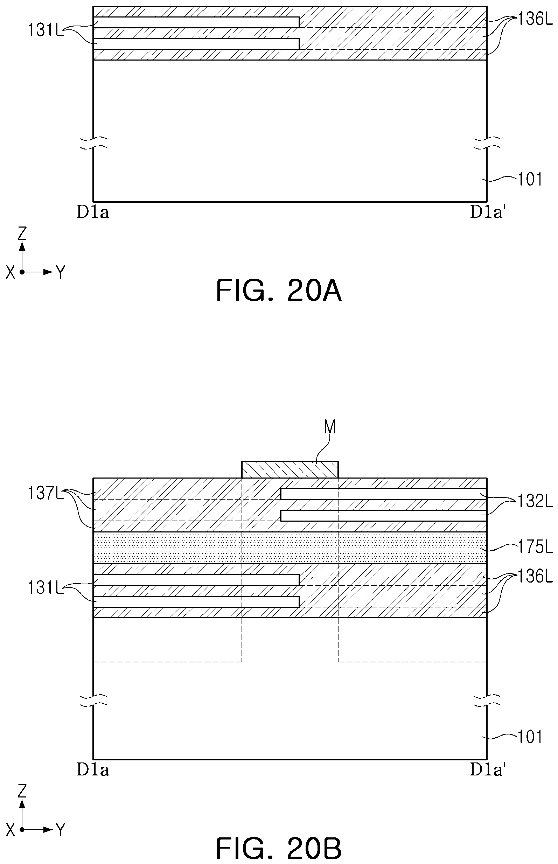

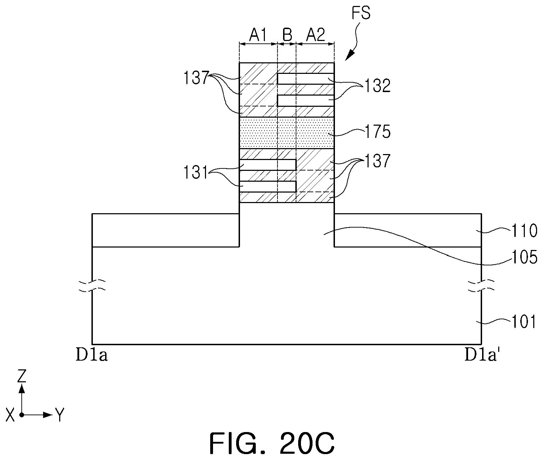

FIGS. 20A to 20C are cross-sectional diagrams illustrating a process of manufacturing a semiconductor device according to an example embodiment. Referring to FIG. 20A, sacrificial layers 136L and first semiconductor layers 131L may be alternately stacked on the substrate 101. Each of the first semiconductor layers 131L may be formed to partially overlap a left region of a portion in which an active pattern (105 in FIG. 20C) is to be formed. Each of the first semiconductor layers 131L may be provided as first semiconductor patterns which may be channel layers. The sacrificial layers 136L may include a material having a high selectivity (e.g. etch selectivity) with respect to the first semiconductor layers 131L. The sacrificial layers 136L may include, for example, either silicon germanium (SiGe) or germanium (Ge). The first semiconductor layers 131L may include, for example, silicon (Si).

Thereafter, referring to FIG. 20B, an intermediate insulating layer 175L may be formed on the sacrificial layers 136L, and the sacrificial layers 136L and the second semiconductor layers 132L may be alternately stacked on the intermediate insulating layer. Subsequently, a mask pattern M may be formed on the stack structure. Each of the second semiconductor layers 132L may be formed to partially overlap a right region of a portion in which an active pattern (dotted line region) is to be formed. Also, the second semiconductor layers 132L may partially overlap the first semiconductor layers 131L in a portion in which an active pattern is to be formed. The second semiconductor layers 132L may be provided as second semiconductor patterns, each of which is a channel layer. The second semiconductor layers 132L may include a material having a high selectivity (e.g. etch selectivity) with a material of the sacrificial layers 136L. The second semiconductor layers 132L may include a material the same as or similar to the first semiconductor layers 131L. The second semiconductor layers 132L may include, for example, silicon (Si).

A mask pattern M defining a region in which a channel structure is to be formed may be formed on the stack structure. The mask pattern M may be used for an active pattern extending in the first direction and an etching process to form a channel structure.

Referring to FIG. 20C, a fin structure FS may be formed by etching the stack structure using a mask pattern M. In this process, an active pattern 105 protruding below the fin structure PS may be formed by further etching a region of the substrate 101. A device isolation layer 110 may be formed around the active pattern 105. The device isolation layer 110 may cover a portion of a side surface of the active pattern 105. That is, the active pattern 105 on the substrate 101 may protrude above the device isolation layer 110. The fin structure FS may include first and second channel structures stacked on the active pattern 105. Each of the first and second channel structures may include a plurality of first and second semiconductor patterns 131 and 132, and a sacrificial layer pattern 137 may remain between the first and second semiconductor patterns 131 and 132. Also, an intermediate insulating pattern 175 may be disposed between the first and second channel structures.

The first and second semiconductor patterns 131 and 132 may have a width smaller than a width of the active pattern 105, the first semiconductor patterns 131 may be stacked adjacent to the left region on the active pattern 105, and the second semiconductor patterns 132 may be stacked adjacent to the right region on the active pattern 105.

The first and second semiconductor patterns 131 and 132 may have non-overlapping regions A1 and A2 in the left and right regions, respectively, but a partial region B of the first and second semiconductor patterns 131 and 132 may overlap in the central region of the active pattern 105. Thereafter, by forming a source/drain pattern after forming a dummy gate structure and replacing the dummy gate structure with an actual gate structure, a semiconductor device 100D illustrated in FIG. 17 may be manufactured.

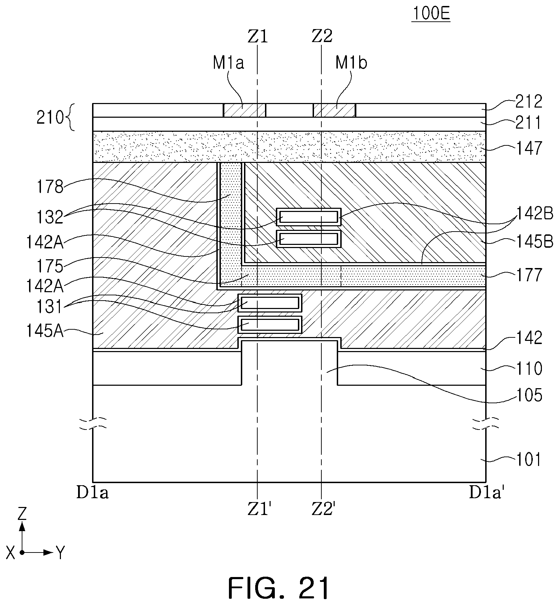

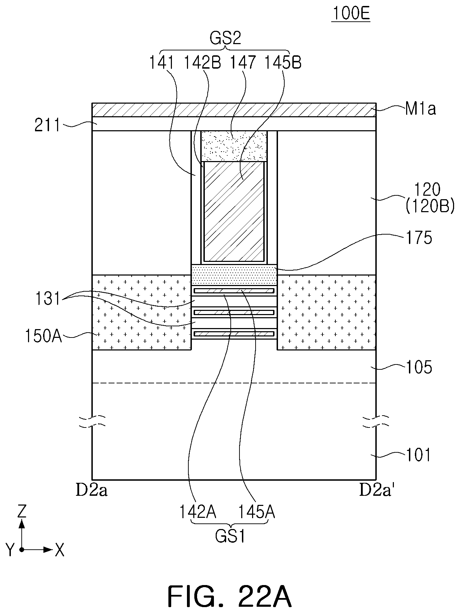

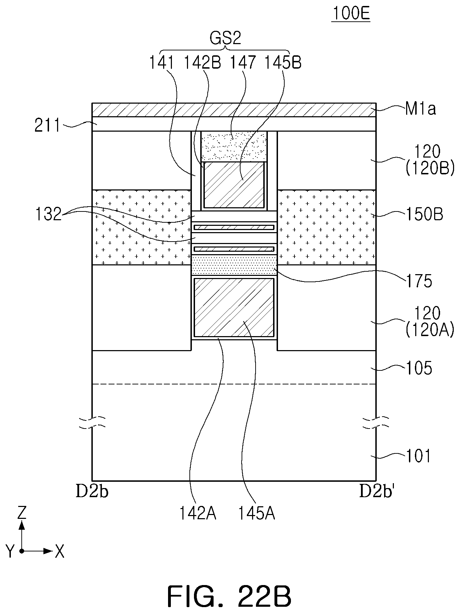

FIG. 21 is a cross-sectional diagram illustrating a semiconductor device according to an example embodiment. FIGS. 22A and 22B are cross-sectional diagrams illustrating the semiconductor device illustrated in FIG. 21 taken along lines Z1-Z1' and Z2-Z2'. Referring to FIGS. 21, 22A and 22B, the semiconductor device 100E according to the example embodiment may have a structure similar to that of the semiconductor device 100D illustrated in FIGS. 18B, 19A and 19B other than the configuration in which the gate structure may include different first and second gate structures GS1 and GS2. Also, components in the example embodiment may be understood by referring to descriptions of the same or similar components of semiconductor devices (in particular, 100 and 100E) in the aforementioned example embodiment, unless otherwise indicated.

The gate structure employed in the example embodiment may include a first gate structure GS1 surrounding a plurality of first semiconductor patterns 131 and a second gate structure GS2 surrounding a plurality of second semiconductor patterns 132. The first and second gate electrodes 145A and 145B may include different electrode materials. Additionally, the first and second gate insulating films 142A and 142B may also include different insulating materials.

After forming the fin structure (see FIG. 20C), in the process of forming the dummy gate structure, by further forming vertical insulating pattern 178 connected to one side of the intermediate insulating pattern 175 along the side surface of the upper region (second channel structure) of the fin structure and horizontal insulating pattern 177 extending in the horizontal direction connected to the other side of intermediate insulating pattern 175, the dummy gate electrode may be divided into first and second dummy electrode portions having open upper portions. Accordingly, similarly to the first and second gate electrode portions 145A and 145B illustrated in FIG. 21, the first dummy electrode portion may surround the first semiconductor patterns 131, and the second dummy electrode portion may surround the second semiconductor patterns 132.

FIGS. 22A and 22B illustrate cross-sectional surfaces of the semiconductor device in FIG. 21 taken along lines Z1-Z1' and Z2-Z2', corresponding to the cross-sectional surfaces taken along lines D2a-D2a' and D2b-D2b' in the structure in FIGS.19A and 19B.

Referring to FIG. 22A, a first gate structure GS1 may be configured to surround the plurality of first semiconductor patterns 131, and the second gate structure GS2 may be disposed on the intermediate insulating pattern 175. Referring to FIG. 22B, a second gate structure GS2 may be configured to surround a plurality of second semiconductor patterns 132, and a first gate structure GS1 may be filled in a region below the intermediate insulating pattern 175. In the channel structure in which the first and second semiconductor patterns 131 and 132 are alternately disposed, the gate structures GS1 and GS2 related to each transistor may be formed of different materials.

According to the aforementioned example embodiments, by combining a device with a 4-stage FET structure with a power transfer structure disposed on the backside of the device, the area of a cell implementing a complex circuit may be greatly reduced. For example, a semiconductor device according to the example embodiment may implement a NAND circuit, a NOR circuit, and an AOI22 circuit in a relatively small cell area.

Embodiments are set out in the following clauses:
Clause 1. A semiconductor device, comprising:
   an active pattern extending in a first direction, on a substrate;
   first to fourth channel structures stacked in order on one region of the active pattern, said first to fourth channel structures including respective first to fourth semiconductor patterns, which are stacked and spaced apart from each other in a vertical direction perpendicular to an upper surface of the substrate;
   a first gate structure that crosses the one region of the active pattern, extends in a second direction intersecting the first direction, and surrounds the first and second semiconductor patterns;
   a second gate structure that extends on the first gate structure, in the second direction, and surrounds the third and fourth semiconductor patterns;
   a pair of first source/drain patterns connected to corresponding ends of the first semiconductor pattern, on opposing sides of the first gate structure;
   a pair of second source/drain patterns connected to corresponding ends of the second semiconductor pattern, on opposing sides of the first gate structure;
   a pair of third source/drain patterns connected to corresponding ends of the third semiconductor pattern, on opposing sides of the second gate structure;
   a pair of fourth source/drain patterns connected to corresponding ends of the fourth semiconductor pattern, on opposing sides of the second gate structure;
   an interlayer insulating layer covering a plurality of the first to fourth source/drain patterns; and
   a plurality of upper wiring lines including at least one upper wiring line electrically coupled through the interlayer insulating layer to at least one of the first through fourth source/drain patterns.
Clause 2. The semiconductor device of Clause 1, further comprising:
   a plurality of upper contact vias electrically connecting each of the plurality of upper wiring lines to at least one of the first to fourth source/drain patterns;
   a plurality of lower wiring lines disposed on a lower surface of the substrate; and
   a plurality of lower contact vias penetrating through the substrate and electrically connecting each of the plurality of lower wiring lines to at least one of the first to fourth source/drain patterns;
   wherein the plurality of lower wiring lines includes a first power line and a second power line; and
   wherein the plurality of lower contact via includes:
      a first power transfer via electrically connecting the first power line to at least one of first to fourth source/drain patterns disposed on one side of the first and second gate structures; and
      a second power transfer via electrically connecting the second power line to at least one of first to fourth source/drain patterns disposed on the other side of the first and second gate structures.
Clause 3. The semiconductor device of Clause 1 or Clause 2, further comprising:
   first contact structures extending in the second direction from each of the first to fourth source/drain patterns disposed on one side of the first and second gate structures, and second contact structures extending in the second direction from each of the first to fourth source/drain patterns disposed on the other side of the first and second gate structures; and
   wherein each of the first and second contact structures is connected to at least one of the plurality of upper and lower contact vias.
Clause 4. The semiconductor device of Clause 3, wherein at least one of the first contact structures extends in a direction opposite to the other first contact structure, and at least one of the second contact structures extends in a direction opposite to the other second contact structure.
Clause 5. The semiconductor device of Clause 3 or Clause 4, wherein at least one of the first and second contact structures has an extended length different from extended lengths of the other contact structures.
Clause 6. The semiconductor device of any of Clauses 3-5, wherein the plurality of upper contact vias include an upper contact via connected to two or more of the first contact structures or two or more of the second contact structures.
Clause 7. The semiconductor device of any of Clauses 3-6, wherein the plurality of lower contact vias includes a lower contact via connected to two or more of the first contact structures or two or more of the second contact structures.
Clause 8. The semiconductor device of any of Clauses 3-7, further comprising:
   an interconnecting via connecting two or more of the first contact structures to each other or two or more of the second contact structures to each other in the interlayer insulating layer.
Clause 9. The semiconductor device of any of Clauses 3-8, wherein the first and third source/drain patterns include a first conductivity-type semiconductor, and the second and fourth source/drain patterns include a second conductivity-type semiconductor.
Clause 10. The semiconductor device of claim 9,
   wherein the plurality of upper wiring lines includes first to third upper wiring lines extending in the first direction; and
   wherein, the first to third upper wiring lines are sequentially arranged in the first direction, and the active pattern is positioned between the second to third upper wiring lines in view of a plane.
Clause 11. The semiconductor device of Clause 10, wherein the plurality of upper contact via includes:
   a first upper contact via electrically connecting the first upper wiring line to the first contact structure of the fourth source/drain pattern;
   a second upper contact via electrically connecting the first upper wiring line to the second contact structure of the second source/drain pattern;
   a third upper contact via electrically connecting the second upper wiring line to the second gate structure; and
   a fourth upper contact via electrically connecting the third upper wiring line to the second contact structures of the first, third and fourth source/drain patterns.
Clause 12. The semiconductor device of Clause 11,
   wherein the plurality of lower wiring lines include a first power line, an intermediate lower wiring line, and a second power line each extending in the first direction; and
   wherein the first power line, the intermediate lower wiring line and the second power line are sequentially arranged in the first direction, and the active pattern is positioned between the first power line and the intermediate lower wiring line in view of a plane.
Clause 13. The semiconductor device of Clause 12, wherein the plurality of lower contact vias include:
   a first lower contact via electrically connecting the first power line to the first contact structure of the first and third source/drain patterns;
   a second lower contact via electrically connecting the intermediate lower wiring line to the first gate structure; and
   a third lower contact via electrically connecting the second power line to the first contact structure of the second source/drain patterns.
Clause 14. The semiconductor device of any preceding Clause, further comprising:
   an inter-gate insulating layer disposed between the first gate structure and the second gate structure.
Clause 15. The semiconductor device of any preceding Clause, further comprising:
   a first intermediate insulating pattern disposed between the first channel structure and the second channel structure; and
   a second intermediate insulating pattern disposed between the third channel structure and the fourth channel structure.
Clause 16. The semiconductor device of any preceding Clause, wherein the first semiconductor pattern is arranged to at least partially overlap the second semiconductor pattern in the vertical direction on the cross-sectional surface in the second direction.
Clause 17. The semiconductor device of Clause 16,
   wherein the plurality of upper contact vias include first and second upper contact vias connected to first and second source/drain patterns disposed on one side of the first gate structure, respectively; and
   wherein the first and second upper contact vias are disposed to overlap each other in the first direction.
Clause 18. The semiconductor device of any preceding Clause, wherein the pair of first source/drain patterns and the pair of second source/drain patterns comprise respective first and second semiconductor materials having opposite conductivity type relative to each other.
Clause 19. A Multi-Bridge-Channel Field Effect Transistor (MBCFET) device, comprising:
   a substrate;
   a first channel structure of a first FET on the substrate, said first channel structure including a first plurality of spaced-apart semiconductor patterns that are in vertical alignment relative to each other, on a surface of the substrate; and
   a second channel structure of a second FET on the first channel structure of the first FET, said second channel structure including a second plurality of spaced-apart semiconductor patterns that are in vertical alignment relative to each other and relative to the first plurality of spaced-apart semiconductor patterns; and
   wherein the first FET is a PMOS transistor and the second FET is an NMOS transistor, or vice versa.
Clause 20. The device of Clause 19, further comprising:
   a third channel structure of a third FET on the second channel structure of the second FET, said third channel structure including a third plurality of spaced-apart semiconductor patterns that are in vertical alignment relative to each other and relative to the second plurality of spaced-apart semiconductor patterns; and
   a fourth channel structure of a fourth FET on the fourth channel structure of the third FET, said fourth channel structure including a fourth plurality of spaced-apart semiconductor patterns that are in vertical alignment relative to each other and relative to the third plurality of spaced-apart semiconductor patterns; and
   wherein the third FET is a PMOS transistor and the fourth FET is an NMOS transistor, or vice versa.
Clause 21. A semiconductor device, comprising:
   an active pattern disposed on a substrate;
   a first channel structure including a plurality of first semiconductor patterns stacked and spaced apart from each other on one region of the active pattern;
   a second channel structure including a plurality of second semiconductor patterns stacked and spaced apart from each other on the first channel structure;
   a third channel structure including a plurality of third semiconductor patterns stacked and spaced apart from each other on the second channel structure;
   a fourth channel structure including a plurality of fourth semiconductor patterns stacked and spaced apart from each other on the third channel structure;
   a gate structure crossing the one region of the active pattern and surrounding the plurality of first to fourth semiconductor patterns;
   a pair of first source/drain patterns connected to both ends of the plurality of first semiconductor patterns, respectively, on both sides of the gate structure;
   a pair of second source/drain patterns disposed on the pair of first source/drain patterns and connected to both ends of the plurality of second semiconductor patterns, respectively;
   a pair of third source/drain patterns disposed on the pair of second source/drain patterns and connected to both ends of the plurality of third semiconductor patterns, respectively;
   a pair of fourth source/drain patterns disposed on the pair of third source/drain patterns and connected to both ends of the plurality of fourth semiconductor patterns, respectively;
   first contact structures connected to the first to fourth source/drain patterns disposed on one side of both sides of the gate structure, respectively;
   second contact structures connected to the first to fourth source/drain patterns disposed on the other side on both sides of the gate structure, respectively;
   a first power line and a second power line disposed on a lower surface of the substrate;
   a first power transfer via penetrating through the substrate and electrically connecting the first power line to at least one of the first contact structures; and
   a second power transfer via penetrating through the substrate and electrically connecting the second power line to at least one of the second contact structures.
Clause 22. The semiconductor device of Clause 21, further comprising:
   an interlayer insulating layer covering the first to fourth source/drain patterns;
   a plurality of first wiring lines disposed on the interlayer insulating layer; and
   a plurality of first contact vias connecting each of the plurality of first wiring lines to at least one of the first and second contact structures.
Clause 23. The semiconductor device of Clause 21 or Clause 22, wherein the plurality of first contact vias include first contact vias connected to two or more of the first contact structures or two or more of the second contact structures.
Clause 24. The semiconductor device of any of Clauses 21-23, further comprising:
   at least one second wiring line disposed on a lower surface of the substrate; and
   at least one second contact via penetrating through the substrate and connecting the at least one second wiring line to at least one of the first and second contact structures.
Clause 25. The semiconductor device of Clause 24, wherein the at least one second contact via includes a second contact via connected to two or more of the first contact structures or two or more of the second contact structures.
Clause 26. A semiconductor device, comprising:
   an active pattern extending on a substrate in a first direction;
   a first channel structure including a plurality of first semiconductor patterns stacked and spaced apart from each other on one region of the active pattern in a vertical direction perpendicular to an upper surface of the substrate;
   a second channel structure including a plurality of second semiconductor patterns stacked and spaced apart from each other in the vertical direction on the first channel structure;
   a third channel structure including a plurality of third semiconductor patterns stacked and spaced apart from each other in the vertical direction on the second channel structure;
   a fourth channel structure including a plurality of fourth semiconductor patterns stacked and spaced apart from each other in the vertical direction on the third channel structure;
   a first intermediate insulating pattern disposed between the first channel structure and the second channel structure;
   a second intermediate insulating pattern disposed between the third channel structure and the fourth channel structure;
   a first gate structure crossing the one region of the active pattern, extending in a second direction intersecting the first direction and surrounding the plurality of first semiconductor patterns and the plurality of second semiconductor patterns;
   a second gate structure extending on the first gate structure in the second direction and surrounding the plurality of third semiconductor patterns and the plurality of fourth semiconductor patterns;
   an inter-gate insulating layer disposed between the first gate structure and the second gate structure;
   a pair of first source/drain patterns disposed on the active pattern on both sides of the first gate structure and connected to both ends of the plurality of first semiconductor patterns, respectively;
   a pair of second source/drain patterns connected to both ends of the plurality of second semiconductor patterns, respectively, on both sides of the first gate structure;
   a pair of third source/drain patterns connected to both ends of the plurality of third semiconductor patterns, respectively, on both sides of the second gate structure;
   a pair of fourth source/drain patterns connected to both ends of the plurality of fourth semiconductor patterns, respectively, on both sides of the second gate structure;
   an interlayer insulating layer covering the first to fourth source/drain patterns;
   a plurality of first wiring lines disposed on the interlayer insulating layer;
   a plurality of first contact vias connecting each of the plurality of first wiring lines to at least one of the first to fourth source/drain patterns through the interlayer insulating layer;
   a plurality of second wiring lines disposed on a lower surface of the substrate; and
   a plurality of second contact vias connecting each of the plurality of second wiring lines to at least one of the first to fourth source/drain patterns through the substrate.
Clause 27. The semiconductor device of Clause 26,
   wherein the plurality of second wiring lines include a first power line and a second power line, and
   wherein the plurality of second contact via includes:
      a first power transfer via electrically connecting the first power line to at least one of first to fourth source/drain patterns disposed on one side of the first and second gate structures; and
      a second power transfer via electrically connecting the second power line to at least one of first to fourth source/drain patterns disposed on the other side of the first and second gate structures.
Clause 28. A semiconductor device, comprising:
   an active pattern extending on a substrate in a first direction;
   a first channel structure including a plurality of first semiconductor patterns stacked and spaced apart from each other on one region of the active pattern in a vertical direction perpendicular to an upper surface of the substrate;
   a second channel structure including a plurality of second semiconductor patterns stacked and spaced apart from each other in the vertical direction on the first channel structure;
   an intermediate insulating pattern disposed between the first channel structure and the second channel structure;
   a gate structure crossing the one region of the active pattern, extending in a second direction intersecting the first direction and surrounding the plurality of first semiconductor patterns and the plurality of second semiconductor patterns;
   a pair of first source/drain patterns disposed on the active pattern on both sides of the gate structure and connected to both ends of the plurality of first semiconductor patterns, respectively; and
   a pair of second source/drain patterns connected to both ends of the plurality of second semiconductor patterns, respectively, on both sides of the gate structure,
   wherein the plurality of first semiconductor patterns are arranged to partially overlap the plurality of second semiconductor patterns in the vertical direction on a cross-sectional surface in the second direction.
Clause 29. The semiconductor device of Clause 28,
   wherein each of the pair of first source/drain patterns has a first region not overlapping the pair of second source/drain patterns in the vertical direction, and
   wherein the semiconductor device further includes a first upper contact via connected to the first region of at least one first source/drain pattern among the pair of first source/drain patterns.
Clause 30. The semiconductor device of Clause 29, further comprising:
   a second upper contact via connected to the at least one first source/drain pattern and a second source/drain pattern disposed on the same side of the gate structure,
   wherein the first and second upper contact vias are disposed to overlap in the first direction.
Clause 31. The semiconductor device of Clause 29 or Clause 30,
   wherein each of the pair of second source/drain patterns has a second region not overlapping the pair of first source/drain patterns in the vertical direction, and
   wherein the semiconductor device further includes a second upper contact via connected to the second region of at least one second source/drain pattern among the pair of second source/drain patterns.

While the example embodiments have been illustrated and described above, it will be configured as apparent to those skilled in the art that modifications and variations may be made without departing from the scope in the example embodiment as defined by the appended claims.

## Claims

1. A semiconductor device, comprising:
an active pattern extending in a first direction, on a substrate;
first to fourth channel structures stacked in order on one region of the active pattern, said first to fourth channel structures including respective first to fourth semiconductor patterns, which are stacked and spaced apart from each other in a vertical direction perpendicular to an upper surface of the substrate;
a first gate structure that crosses the one region of the active pattern, extends in a second direction intersecting the first direction, and surrounds the first and second semiconductor patterns;
a second gate structure that extends on the first gate structure, in the second direction, and surrounds the third and fourth semiconductor patterns;
a pair of first source/drain patterns connected to corresponding ends of the first semiconductor pattern, on opposing sides of the first gate structure;
a pair of second source/drain patterns connected to corresponding ends of the second semiconductor pattern, on opposing sides of the first gate structure;
a pair of third source/drain patterns connected to corresponding ends of the third semiconductor pattern, on opposing sides of the second gate structure;
a pair of fourth source/drain patterns connected to corresponding ends of the fourth semiconductor pattern, on opposing sides of the second gate structure;
an interlayer insulating layer covering a plurality of the first to fourth source/drain patterns;
a plurality of upper wiring lines including at least one upper wiring line electrically coupled through the interlayer insulating layer to at least one of the first through fourth source/drain patterns;
a plurality of upper contact vias electrically connecting each of the plurality of upper wiring lines to at least one of the first to fourth source/drain patterns;
a plurality of lower wiring lines disposed on a lower surface of the substrate; and
a plurality of lower contact vias penetrating through the substrate and electrically connecting each of the plurality of lower wiring lines to at least one of the first to fourth source/drain patterns.

2. The semiconductor device of claim 1, wherein the plurality of lower wiring lines includes a first power line and a second power line; and
wherein the plurality of lower contact via includes:
a first power transfer via electrically connecting the first power line to at least one of first to fourth source/drain patterns disposed on one side of the first and second gate structures; and
a second power transfer via electrically connecting the second power line to at least one of first to fourth source/drain patterns disposed on the other side of the first and second gate structures.

3. The semiconductor device of claim 1 or claim 2, further comprising:
first contact structures extending in the second direction from each of the first to fourth source/drain patterns disposed on one side of the first and second gate structures, and second contact structures extending in the second direction from each of the first to fourth source/drain patterns disposed on the other side of the first and second gate structures; and
wherein each of the first and second contact structures is connected to at least one of the plurality of upper and lower contact vias.

4. The semiconductor device of claim 3, wherein at least one of the first contact structures extends in a direction opposite to one or more other first contact structures, and at least one of the second contact structures extends in a direction opposite to one or more other second contact structures.

5. The semiconductor device of claim 3 or claim 4, wherein at least one of the first and second contact structures has an extended length different from extended lengths of the one or more other contact structures of the first and second contact structures.

6. The semiconductor device of any of claims 3-5, wherein the plurality of upper contact vias include an upper contact via connected to two or more of the first contact structures or two or more of the second contact structures.

7. The semiconductor device of any of claims 3-6, wherein the plurality of lower contact vias includes a lower contact via connected to two or more of the first contact structures or two or more of the second contact structures.

8. The semiconductor device of any of claims 3-7, further comprising:
an interconnecting via connecting two or more of the first contact structures to each other or two or more of the second contact structures to each other in the interlayer insulating layer.

9. The semiconductor device of any of claims 3-8, wherein the first and third source/drain patterns include a first conductivity-type semiconductor, and the second and fourth source/drain patterns include a second conductivity-type semiconductor.

10. The semiconductor device of claim 9,
wherein the plurality of upper wiring lines includes first to third upper wiring lines extending in the first direction; and
wherein, the first to third upper wiring lines are sequentially arranged in the second direction, and the active pattern is positioned between the second and third upper wiring lines in plan view.

11. The semiconductor device of claim 10, wherein the plurality of upper contact vias includes:
a first upper contact via electrically connecting the first upper wiring line to the first contact structure of the fourth source/drain pattern;
a second upper contact via electrically connecting the first upper wiring line to the second contact structure of the second source/drain pattern;
a third upper contact via electrically connecting the second upper wiring line to the second gate structure; and
a fourth upper contact via electrically connecting the third upper wiring line to the second contact structures of the first, third and fourth source/drain patterns.

12. The semiconductor device of any of claims 9-11,
wherein the plurality of lower wiring lines include a first power line, an intermediate lower wiring line, and a second power line each extending in the first direction; and
wherein the first power line, the intermediate lower wiring line and the second power line are sequentially arranged in the second direction, and the active pattern is positioned between the first power line and the intermediate lower wiring line in plan view.

13. The semiconductor device of claim 12, wherein the plurality of lower contact vias include:
a first lower contact via electrically connecting the first power line to the first contact structure of the first and third source/drain patterns;
a second lower contact via electrically connecting the intermediate lower wiring line to the first gate structure; and
a third lower contact via electrically connecting the second power line to the first contact structure of the second source/drain patterns.

14. The semiconductor device of any preceding claim, further comprising:
an inter-gate insulating layer disposed between the first gate structure and the second gate structure,
a first intermediate insulating pattern disposed between the first channel structure and the second channel structure; and
a second intermediate insulating pattern disposed between the third channel structure and the fourth channel structure.

15. The semiconductor device of any preceding claim, wherein the first semiconductor pattern is arranged to at least partially overlap the second semiconductor pattern in the vertical direction when viewed in a cross-sectional view taken along the second direction.
